# EUROPEAN PATENT SPECIFICATION

(11) **EP 1 900 845 B1**
(45) Date of publication and mention of the grant of the patent: **04.05.2016**
(21) Application number: 07120523.1
(22) Date of filing: 07.12.2005
(51) Int. Cl.: C23C 14/58, C23C 14/08, H01M 6/18, H01M 6/46, H01M 10/0562, H01M 10/052, H01M 4/525, H01M 4/1391, H01M 4/04, H01M 10/0585

(54) **Deposition of LiCoO2**
Abscheidung von LiCoO2
Dépôt de LiCoO2

(30) Priority: 08.12.2004 US 634818 P; 08.02.2005 US 651363 P
(43) Date of publication of application: 19.03.2008
(62) Divisional of application: 05853649.1
(73) Proprietor: Sapurast Research LLC, Wilmington, DE 19801 (US)
(72) Inventor: ZHANG, Hongmei, San Jose, CO 95118 (US); DEMARAY, Richard E., Portola Valley, CA 94028 (US); NEUDECKER, Bernd J., Littleton, CO 80127 (US)
(74) Representative: Barnfather, Karl Jon

(56) References cited:
- US-A1- 2003 173 207
- KIM HAN-KI ET AL: "Characteristics of rapid-thermal-annealed LiCoO2 cathode film for an all-solid-state thin film microbattery" JOURNAL OF VACUUM SCIENCE AND TECHNOLOGY A. VACUUM, SURFACES AND FILMS, AMERICAN INSTITUTE OF PHYSICS, NEW YORK, NY, US, vol. 22, no. 4, July 2004 (2004-07), pages 1182-1187, XP012073711 ISSN: 0734-2101
- HWANG ET AL: "Characterisation of Sputter-Deposited LiMnO4 Thin Films for Rechargeable Microbatteries" J.ELECTROCHEM SOC:, vol. 141, no. 12, December 1994 (1994-12), pages 3296-3299, XP002467098

## Description

### RELATED APPLICATION

The present application claims priority to Provisional Application No. 60/651,363, filed on February 8, 2005 (published as US 2006/134522), by Hongmei Zhang and Richard E. Demaray, and to Provisional Application No. 60/634,818 (also published as US 2006/134522), filed on December 8, 2004, by the same inventors.

### BACKGROUND

### 1. Field of the Invention

The present invention is related to thin-film solid-state batteries and, in particular, the deposition of LiCoO2 films and layers for battery manufacture.

### 2. Discussion of Related Art

Solid-state thin-film batteries are typically formed by stacking thin films on a substrate in such a way that the films cooperate to generate a voltage. The thin films typically include current collectors, a cathode, an anode, and an electrolyte. The thin films can be deposited utilizing a number of deposition processes, including sputtering and electroplating. Substrates suitable for this application have conventionally been high temperature materials capable of withstanding at least one high temperature anneal process to at least 700°C for up to about 2 hours in air so as to crystallize the LiCoO₂ film. Such a substrate can be any suitable material with appropriate structural and material properties, for example a semiconductor wafer, metallic sheet (e.g., titanium or zirconium), ceramic such as alumina, or other material capable of withstanding subsequent high temperature processing in the presence of the LiCoO₂, which can experience significant interfacial reactions with most materials utilized in a battery during these temperature cycles.

Other lithium containing mixed metal oxides besides LiCoO₂, including Ni, Nb, Mn, V, and sometimes also Co, but including other transition metal oxides, have been evaluated as crystalline energy storage cathode materials. Typically, the cathode material is deposited in amorphous form and then the material is heated in an anneal process to form the crystalline material. In LiCoO₂, for example, an anneal at or above 700°C transforms the deposited amorphous film to a crystalline form. Such a high temperature anneal, however, severely limits the materials that can be utilized as the substrate, induces destructive reaction with the lithium containing cathode material and often requires the use of expensive noble metals such as gold. Such high thermal budget processes (i.e., high temperatures for extended periods of time) are incompatible with semiconductor or MEM device processing and limit the choice of substrate materials, increase the cost, and decrease the yield of such batteries. The inventors are unaware of a process disclosed in the art that allows production of cathodic lithium films for a battery structure where a post-deposition anneal process has a low enough thermal budget to allow production of functional structures on low temperature materials such as stainless steel, aluminum, or copper foil.

It is known that crystallization of amorphous LiCoO₂ on precious metals can be achieved. An example of this crystallization is discussed in Kim et al., where a conventional furnace anneal at 700°C for 20 minutes of an amorphous layer of LiCoO₂ on a precious metal achieves crystallization of the LiCoO₂ material, as shown by x-ray diffraction data. Kim, Han-Ki and Yoon, Young Soo, "Characteristics of rapid-thermal-annealed LiCoO2, cathode film for an all-solid-state thin film microbattery," J. Vac. Sci. Techn. A 22(4), Jul/Aug 2004. In Kim et al., the LiCoO₂ film was deposited on a platinum film that was deposited on a high-temperature MgO/Si substrate. In Kim et al, it was shown that such a crystalline film is capable of constituting the Li+ ion containing cathode layer of a functional all solid-state Li+ ion battery. However, it is of continuing interest for the manufacture of solid state Li+ ion batteries to further reduce the thermal budget of the post deposition anneal, both in time and in temperature, so as to enable the manufacture of such batteries without the need for expensive precious metal nucleation, barrier layers, or expensive high-temperature substrates.

There are many references that disclose an ion beam assisted process that can provide a LiCoO₂ film that demonstrates some observable crystalline composition by low angle x-ray diffraction (XRD). Some examples of these are found in U.S. Patent Applications 09/815,983 (Publication No. US 2002/001747), 09/815,621 (Publication No. US 2001/0032666), and 09/815,919 (Publication No. US 2002/0001746). These references disclose the use of a second front side ion beam or other ion source side-by-side with a deposition source so as to obtain a region of overlap of the flux of ions with the flux of LiCoO₂ vapor at the substrate surface. None of these references disclose film temperature data or other temperature data of the film during deposition to support an assertion of low temperature processing.

It is very difficult to form a uniform deposition either by sputtering a material layer or by bombardment with an ion flux. Utilization of two uniform simultaneous distributions from two sources that do not occupy the same position and extent with respect to the substrate enormously increases the difficulties involved in achieving a uniform material deposition. These references do not disclose a uniform materials deposition, which is required for reliable production of thin-film batteries. A well understood specification for material uniformity for useful battery products is that a 5% one-sigma material uniformity is standard in thin film manufacturing. About 86% of the films with this uniformity will be found acceptable for battery production.

It is even more difficult to scale a substrate to manufacturing scale, such as 200 mm or 300 mm. Indeed, in the references discussed above that utilize both a sputtering deposition and an ion beam deposition, only small area targets and small area substrates are disclosed. These references disclose a single feasibility result. No method for achieving a uniform distribution from two separate front side sources has been disclosed in these references.

Further, conventional materials and production processes can limit the energy density capacity of the batteries produced, causing a need for more batteries occupying more volume. It is specifically desirable to produce batteries that have large amounts of stored energy per unit volume in order to provide batteries of low weight and low volume.

Therefore, there is a need for a low temperature process for depositing crystalline material, for example LiCoO₂ material, onto a substrate.

### SUMMARY

According to a first aspect of the invention, there is provided a method of depositing a LiCoO₂ layer according to appended claim 1. According to a second aspect of the invention, there is provided a method of producing a battery according to appended claim 18. Preferable features of the invention are defined in the appended dependent claims.

In accordance with the present invention, deposition of LiCoO₂ layers in a pulsed-dc physical vapor deposition process is presented. Such a deposition can provide a low-temperature, high deposition rate deposition of a crystalline layer of LiCoO₂ with a desired <101> orientation. Some embodiments of the deposition address the need for high rate deposition of LiCoO₂ films, which can be utilized as the cathode layer in a solid state rechargeable Li battery. Embodiments of the process according to the present invention can eliminate the high temperature (>700 °C) anneal step that is conventionally needed to crystallize the LiCoO₂ layer.

A method of depositing a LiCoO₂ layer according to some embodiments of the present invention includes placing a substrate in a reactor; flowing a gaseous mixture including argon and oxygen through the reactor; and applying pulsed-DC power to a target formed of LiCoO₂ positioned opposite the substrate. In some embodiments, a LiCoO₂ layer is formed on the substrate. Further, in some embodiments the LiCoO₂ layer is a crystalline layer of orientation <101>.

In some embodiments, a stacked battery structure can be formed. The stacked battery structure includes one or more battery stacks deposited on a thin substrate, wherein each battery stack includes: a conducting layer, a crystalline LiCoO₂ layer deposited over the conducting layer, a LiPON layer deposited over the LiCoO₂ layer; and an anode deposited over the LiPON layer. A top conducting layer can be deposited over the one or more battery stacks.

In some embodiments, a battery structure can be formed in a cluster tool. A method of producing a battery in a cluster tool includes loading a substrate into a cluster tool; depositing a conducting layer over the substrate in a first chamber of the cluster tool; depositing a crystalline LiCoO₂ layer over the conducting layer in a second chamber of the cluster tool; depositing a LiPON layer over the LiCoO₂ layer in a third chamber of the cluster tool; depositing an anode layer over the LiCoO₂ layer in a fourth chamber; and depositing a second conducting layer over the LiPON layer in a fifth chamber of the cluster tool.

A fixture for holding a thin substrate can include a top portion and a bottom portion, wherein the thin substrate is held when the top portion is attached to the bottom portion.

These and other embodiments of the invention are further discussed below with reference to the following figures. It is to be understood that both the foregoing general description and the following detailed description are exemplary and explanatory only and are not restrictive of the invention, as claimed. Further, specific explanations or theories regarding the deposition or performance of certain layers during deposition processes or in the performance of devices incorporating those layers are presented for explanation only and are not to be considered limiting with respect to the scope of the present disclosure or the claims.

### BRIEF DESCRIPTION OF THE DRAWINGS

Figures 1A and 1B illustrate a pulsed-DC biased reactive deposition apparatus that can be utilized in the methods of depositing according to the present invention.
Figure 2 shows an example of a target that can be utilized in the reactor illustrated in Figures 1A and 1B.
Figure 3 illustrates a thin-film battery design according to some embodiments of the present invention.
Figures 4A and 4B show an x-ray diffraction analysis of and an SEM photograph of a LiCoO₂ film deposited according to embodiments of the present invention.
Figures 5A through 5F show SEM photographs of LiCoO₂ films according to some embodiments of the present invention.
Figure 5G shows x-ray diffraction data corresponding to the depositions shown in Figures 5B-5F.
Figure 6A illustrates a layer of LiCoO₂ deposited according to some embodiments of the present invention on a thin substrate.
Figure 6B illustrates a layer of LiCoO₂ deposited according to some embodiments of the present invention over a conducting layer on a thin substrate.
Figures 7A, 7B, 7C, and 7D illustrate a thin substrate mount and mask arrangement that can be utilized in the deposition of LiCoO₂ layers deposited according to some embodiments of the present invention.
Figure 8 illustrates a cluster tool that can be utilized to form batteries with LiCoO₂ layers deposited according to some embodiments of the present invention.
Figures 9A and 9B illustrate examples of stacked batter structures with LiCoO₂ layers deposited according to some embodiments of the present invention.
Figures 10A through 10D illustrate deposition and anneal steps for LiCoO₂ deposited over an iridium layer on a silicon wafer.
Figures 11A through 11 D illustrate a single layer battery formed over an iridium layer according to some embodiments of the present invention.
Figures 12A through 12L illustrate deposition of a crystalline LiCoO₂ layer on a silicon or alumina substrate.
Figures 13A through 13F illustrate rapid thermal anneal processes for LiCoO₂ layers deposited according to the present invention.
Figures 14A through 14D illustrate several anneal processes utilized with a LiCoO₂ film deposited according to embodiments of the present invention.
Figures 15A and 15B illustrate the effects of ramp-time in a rapid thermal anneal of LiCoO₂ films deposited according to the present invention.
Figure 16 illustrates thickness uniformity of a LiCoO₂ film deposited according to some embodiments of the present invention.
Figure 17 illustrates battery charge and discharge profiles of a battery formed utilizing a LiCoO₂ film according to some embodiments of the present invention.

In the figures, elements having the same designation have the same or similar functions.

### DETAILED DESCRIPTION

In accordance with embodiments of the present invention, LiCoO₂ films are deposited on a substrate by a pulsed-dc physical vapor deposition (PVD) process. In contrast to, for example, Kim et al., LiCoO₂ films according to some embodiments of the present invention provide a crystalline LiCoO₂ film as deposited on a substrate at a substrate temperature as low as about 220°C during deposition, without the use of a metallic nucleation or barrier underlying film. The as-deposited crystalline LiCoO₂ films can be easily ripened to very high crystalline condition by anneal at about 700 °C for as little as 5 minutes without the use of an underlying precious metal films. In addition, the as deposited crystalline films, when positioned on a noble metal film can be annealed at much further reduced temperatures, for example as low as 400 to 500 °C, providing for deposition, annealing, and production of solid state batteries on lower temperature substrates.

In the present application, a single, extended source is described which has been scaled to 400mm X 500mm for production achieving a LiCoO₂ uniformity of 3% one-stigma measured at 25 points at a deposition rate of 1.2 microns thickness an hour over an area of 2000 cm², without the need for secondary front side ion source or ion assistance.

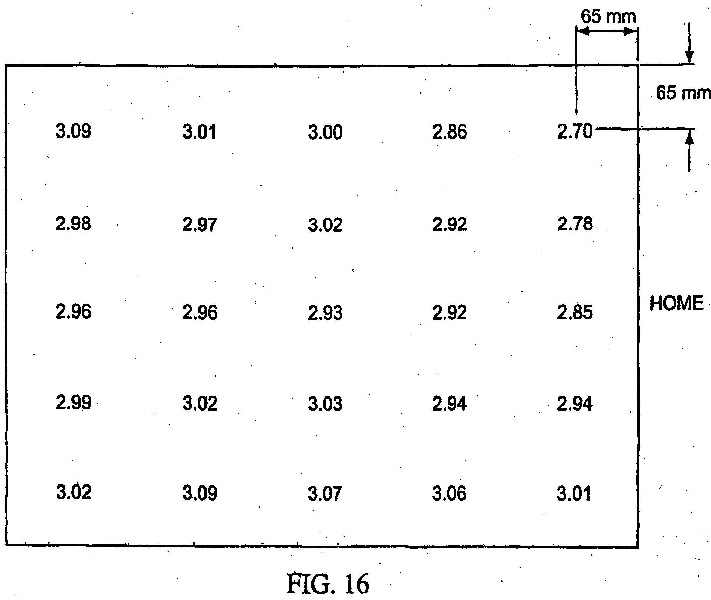

In one example process, a LiCoO₂ film was deposited utilizing a conductive ceramic LiCoO₂ target as described herein, with pulsed-dc power of 4 kW, no bias, with 60 sccm Ar and 20 sccm O₂ gas flows. A 3000 Angstrom layer of crystalline LiCoO₂ was deposited on a substrate area of 400 X 500 mm. As demonstrated in Figure 16, film thickness uniformity was located at about 25 locations spaced uniformly across the substrate using a felt marker pen to lift off a portion of the film in each location. High precision white-light interferometry was utilized to measure the film thickness in each location by measuring the step height from the substrate to film surface. All 25 thickness measurements demonstrated a 3% one-sigma uniformity in the film thickness over 400 X 500 mm substrate area. As shown in Figure 16, a film was deposited with average thickness of about 2.96 µm with a maximum of 3.09 µm and a minimum of 2.70 µm and standard deviation of 0.093. Thickness data was taken at points spaced 0.65 mm apart on the surface of the film. The film thickness therefore showed 3% one-sigma uniformity over the shown surface area.

On other depositions utilizing this process, a temperature measurement of the substrate during deposition showed that the substrate remained at less than 224 °C. Temperature measurements were performed utilizing a temperature sticker purchased from Omega Engineering, Stamford, Ct (Model no. TL-F-390, active from 199-224 °C).

Moreover, in some embodiments, films deposited according to the present invention can have a deposition rate of from about 10 to about 30 times higher than processes in conventional films. Deposition thicknesses and times of deposition for films deposited according to the present invention are illustrated in Table I. Furthermore, films according to the present invention can be deposited on wide area substrates having a surface area from 10 to 50 times the surface area of prior sputtering processes, resulting in much higher productivity and much lower cost of manufacture, thereby providing high-volume, low-cost batteries.

Further, conventional deposition processes without ion sources are capable of depositing amorphous LiCoO₂ layers, but do not deposit crystalline LiCoO₂ layers. Surprisingly, depositions according to some embodiment of the present invention, deposit a LiCoO₂ layer with substantial crystallinity readily measured by x-ray diffraction techniques. In some embodiments, the crystallinity of the as-deposited LiCoO₂ layers is sufficient to be utilized in a battery structure with no further thermal processing. In some embodiments, crystallinity of the as-deposited LiCoO₂ layers are improved by thermal processes with low thermal budgets, which can be compatible with films deposited on low-temperature substrates.

Further, as-deposited the stoichiometry of some LiCoO₂ layers deposited according to some embodiments of the present invention shows that this layer is sufficient for utilization in a battery. With the demonstrated ability to deposit a LiCoO₂ film with crystallinity and with sufficient stoichiometry, a battery utilizing as-deposited LiCoO₂ films can be produced. Heat treating the LiCoO2 layers may improve the crystallinity and lower the impedance.

In some embodiments, a crystalline layer Of LiCoO₂ with a <101> or a <003> crystalline orientation is deposited directly on the substrate. Deposition of crystalline material can eliminate or lessen the need of a subsequent high temperature anneal or precious-metal layers to crystallize and orient the film. Removing the high temperature anneal allows for formation of battery structures on light-weight and low temperature substrates such as stainless steel foil, copper foil, aluminum foil, and plastic sheet, reducing both the weight and the cost of batteries while retaining the energy density storage capabilities of Li-based batteries. In some embodiments, a crystalline LiCoO₂ layer can be deposited on a precious metal layer, such as platinum or iridium, resulting in a further significant lowering of the ripening thermal budget required to improve crystallinity.

Deposition of materials by pulsed-DC biased reactive ion deposition is described in U.S. Patent Application Serial No. 10/101863 (US publication number US2003/0173207), entitled "Biased Pulse DC Reactive Sputtering of Oxide Films," to Hongmei Zhang, et al., filed on March 16, 2002. Preparation of targets is described in U.S. Patent Application Serial No. 10/101,341 (US publication number US2003/0175142), entitled "Rare-Earth Pre-Alloyed PVD Targets for Dielectric Planar Applications," to Vassiliki Milonopoulou, et al., filed on March 16, 2002. U.S. Patent Application Serial No. 10/101863 and U.S. Patent Application Serial No. 10/101,341 are each assigned to the same assignee as is the present disclosure. Deposition of oxide materials has also been described in U.S. Patent No. 6,506,289. Transparent oxide films can be deposited utilizing processes similar to those specifically described in U.S. Patent No. 6,506,289 and U.S. Application Serial No. 10/101863.

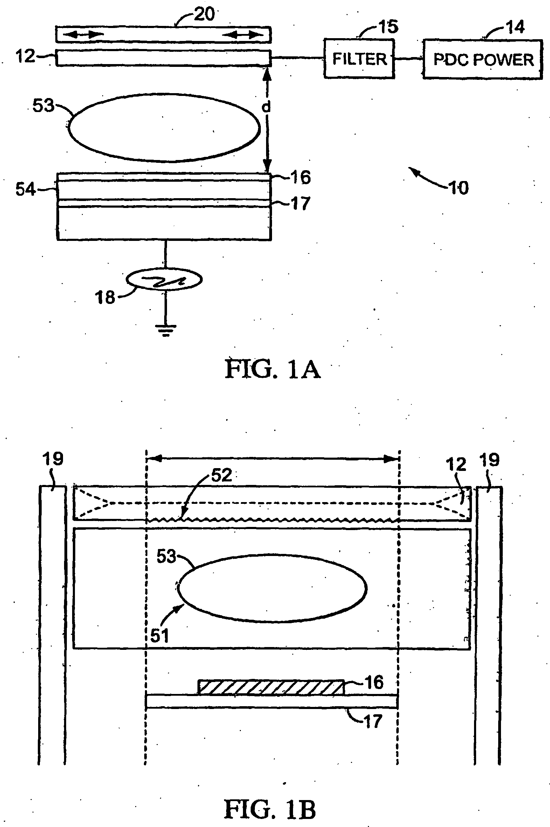

Figure 1A shows a schematic of a reactor apparatus 10 for sputtering material from a target 12 according to the present invention. In some embodiments, apparatus 10 may, for example, be adapted from an AKT-1600 PVD (400 X 500 mm substrate size) system from Applied Komatsu or an AKT-4300 (600 X 720 mm substrate size) system from Applied Komatsu, Santa Clara, CA. The AKT-1600 reactor, for example, has three deposition chambers connected by a vacuum transport chamber. These AKT reactors can be modified such that pulsed DC power is supplied to the target and RF power is supplied to the substrate during deposition of a material film. Apparatus 10 can also be a Phoenix Gen III PVD cluster tool made by Symmorphix, which is specifically designed for pulsed-dc processes such as is described herein.

Apparatus 10 includes target 12 which is electrically coupled through a filter 15 to a pulsed DC power supply 14. In some embodiments, target 12 is a wide area sputter source target, which provides material to be deposited on a substrate 16. Substrate 16 is positioned parallel to and opposite target 12. Target 12 functions as a cathode when power is applied to it from the pulsed DC power supply 14 and is equivalently termed a cathode. Application of power to target 12 creates a plasma 53. Substrate 16 is capacitively coupled to an electrode 17 through an insulator 54. Electrode 17 can be coupled to an RF power supply 18. A magnet 20 is scanned across the top of target 12.

For pulsed reactive dc magnetron sputtering, as performed by apparatus 10, the polarity of the power supplied to target 12 by power supply 14 oscillates between negative and positive potentials. During the positive period, the insulating layer on the surface of target 12 is discharged and arcing is prevented. To obtain arc free deposition, the pulsing frequency exceeds a critical frequency that can depend on target material, cathode current and reverse time. High quality oxide films can be made using reactive pulse DC magnetron sputtering as shown in apparatus 10.

Pulsed DC power supply 14 can be any pulsed DC power supply, for example an AE Pinnacle plus 10K by Advanced Energy, Inc. With this DC power supply, up to 10 kW of pulsed DC power can be supplied at a frequency of between 0 and 350 kHz. The reverse voltage can be 10% of the negative target voltage. Utilization of other power supplies can lead to different power characteristics, frequency characteristics, and reverse voltage percentages. The reverse time on this embodiment of power supply 14 can be adjusted between 0 and 5 µs.

Filter 15 prevents the bias power from power supply 18 from coupling into pulsed DC power supply 14. In some embodiments, power supply 18 can be a 2 MHz RF power supply, for example a Nova-25 power supply made by ENI, Colorado Springs, Co.

In some embodiments, filter 15 can be a 2 MHz sinusoidal band rejection filter. In some embodiments, the band width of the filter can be approximately 100 kHz. Filter 15, therefore, prevents the 2 MHz power from the bias to substrate 16 from damaging power supply 14 and allow passage of the pulsed-dc power and frequency.

Pulsed DC deposited films are not fully dense and may have columnar structures. Columnar structures can be detrimental to thin film applications such as barrier films and dielectric films, where high density is important, due to the boundaries between the columns. The columns act to lower the dielectric strength of the material, but may provide diffusion paths for transport or diffusion of electrical current, ionic current, gas, or other chemical agents such as water. In the case of a solid state battery, a columnar structure containing crystallinity as derived from processes according to the present invention is beneficial for battery performance because it allows better Li transport through the boundaries of the material.

In the Phoenix system, for example, target 12 can have an active size of about 800.00 X 920.00 mm by 4 to 8 mm in order to deposit films on substrate 16 that have dimension about 600 X 720 mm. The temperature of substrate 16 can be adjusted to between -50 °C and 500°C. The distance between target 12 and substrate 16 can be between about 3 and about 9 cm (in some embodiments, between 4.8 and 6 cm are used). Process gas can be inserted into the chamber of apparatus 10 at a rate up to about 200 seem while the pressure in the chamber of apparatus 10 can be held at between about .7 and 6 milliTorr. Magnet 20 provides a magnetic field of strength between about 400 and about 600 Gauss directed in the plane of target 12 and is moved across target 12 at a rate of less than about 20-30 sec/scan. In some embodiments utilizing the Phoenix reactor, magnet 20 can be a race-track shaped magnet with dimensions about 150 mm by 800 mm.

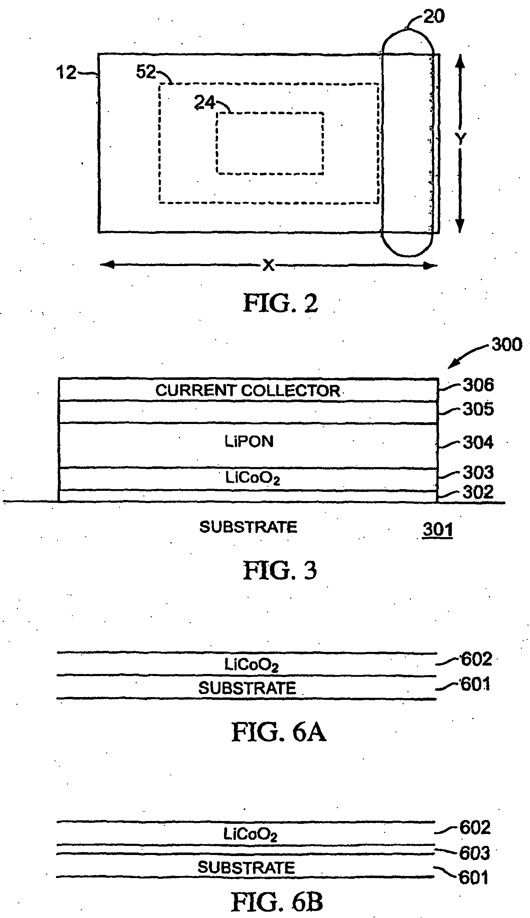

Figure 2 illustrates an example of target 12. A film deposited on a substrate positioned on carrier sheet 17 directly opposed to region 52 of target 12 has good thickness uniformity. Region 52 is the region shown in Figure 1B that is exposed to a uniform plasma condition. In some implementations, carrier 17 can be coextensive with region 52. Region 24 shown in Figure 2 indicates the area below which both physically and chemically uniform deposition can be achieved, for example where physical and chemical uniformity provide refractive index uniformity, oxide film uniformity, or metallic film uniformity. Figure 2 indicates region 52 of target 12 that provides thickness uniformity, which is, in general, larger than region 24 of target 12 providing thickness and chemical uniformity to the deposited film. In optimized processes, however, regions 52 and 24 may be coextensive.

In some embodiments, magnet 20 extends beyond area 52 in one direction, for example the Y direction in Figure 2, so that scanning is necessary in only one direction, for example the X direction, to provide a time averaged uniform magnetic field. As shown in Figures 1A and 1B, magnet 20 can be scanned over the entire extent of target 12, which is larger than region 52 of uniform sputter erosion. Magnet 20 is moved in a plane parallel to the plane of target 12.

The combination of a uniform target 12 with a target area 52 larger than the area of substrate 16 can provide films of highly uniform thickness. Further, the material properties of the film deposited can be highly uniform. The conditions of sputtering at the target surface, such as the uniformity of erosion, the average temperature of the plasma at the target surface, and the equilibration of the target surface with the gas phase ambient of the process are uniform over a region which is greater than or equal to the region to be coated with a uniform film thickness. In addition, the region of uniform film thickness is greater than or equal to the region of the film which is to have highly uniform electrical, mechanical, or optical properties such as index of refraction, stoichiometry, density, transmission, or absorptivity.

Target 12 can be formed of any materials that provide the correct stoichiometry for LiCoO₂ deposition. Typical ceramic target materials include oxides of Li and Co as well as metallic Li and Co additions and dopants such as Ni, Si, Nb, or other suitable metal oxide additions. In the present disclosure, target 12 can be formed from LiCoO₂ for deposition of LiCoO₂ film.

In some embodiments of the invention, material tiles are formed. These tiles can be mounted on a backing plate to form a target for apparatus 10. A wide area sputter cathode target can be formed from a close packed array of smaller tiles. Target 12, therefore, may include any number of tiles, for example between 2 and 60 individual tiles. Tiles can be finished to a size so as to provide a margin of edge-wise non-contact, tile to tile, less than about 0.010" to about 0.020" or less than half a millimeter so as to eliminate plasma processes that may occur between adjacent ones of tiles 30. The distance between tiles of target 12 and the dark space anode or ground shield 19 in Figure 1B can be somewhat larger so as to provide non contact assembly or to provide for thermal expansion tolerance during process chamber conditioning or operation.

As shown in Figure 1B, a uniform plasma condition can be created in the region between target 12 and substrate 16 in a region overlying substrate 16. A plasma 53 can be created in region 51, which extends under the entire target 12. A central region 52 of target 12 can experience a condition of uniform sputter erosion. As discussed further herein, a layer deposited on a substrate placed anywhere below central region 52 can then be uniform in thickness and other properties (i.e., dielectric, optical index, or material concentrations). In some embodiments, target 12 is substantially planar in order to provide uniformity in the film deposited on substrate 16. In practice, planarity of target 12 can mean that all portions of the target surface in region 52 are within a few millimeters of a planar surface, and can be typically within 0.5 mm of a planar surface.

Figure 3 shows a battery structure with a LiCoO₂ layer deposited according to some embodiments of the present invention. As shown in Figure 3, a metallic current collection layer 302 is deposited on a substrate 301. In some embodiments, current collection layer 302 can be patterned in various ways before deposition of a LiCoO₂ layer 303. Also according to some embodiments, LiCoO₂ layer 303 can be a deposited crystalline layer. In some embodiments of the invention, layer 303 is crystalline without the necessity of a crystallizing heat treatment. Therefore, substrate 301 can be a silicon wafer, titanium metal, alumina, or other conventional high temperature substrate, but may also be a low temperature material such as plastic, glass, or other material which could be susceptible to damage from the high temperature crystallizing heat treatment This feature can have the great advantage of decreasing the expense and weight of battery structures formed by the present invention. The low temperature deposition of the LiCoO₂ allows for successive depositions of battery layers, one upon another. Such a process would have the advantage that successive layers of battery structure would be obtained in a stacked condition without the inclusion of a substrate layer. The stacked layered battery would provide higher specific energy density as well as low impedance operation for charging and discharging.

In some embodiments, an oxide layer can be deposited on substrate 301. For example, a silicon oxide layer can be deposited on a silicon wafer. Other layers can be formed between conducting layer 302 and substrate 301.

As further shown in Figure 3, a LiPON layer 304 (LiₓPO_{y}N_{z},) is deposited over LiCoO₂ layer 303. LiPON layer 304 is the electrolyte for battery 300 while LiCoO₂ layer 303 acts as the cathode. A metallic conducting layer 305 can be deposited over the LiPON layer 304 in order to complete the battery. Metallic conducting layer 305 can include lithium adjacent to LiPON layer 304.

An anode 305 is deposited over LiPON layer 304. Anode 305 can be, for example an evaporated lithium metal. Other materials such as, for example, nickel can also be utilized. A current collector 306, which is a conducting material, is then deposited over at least a portion of anode 305.

A Li based thin film battery operates by transport of Li ions in the direction from current collector 306 to current collector 302 in order to hold the voltage between current collector 306 and current collector 302 at a constant voltage. The ability for battery structure 300 to supply steady current, then, depends on the ability of Li ions to diffuse through LiPON layer 304 and LiCoO₂ layer 303. Li transport through bulk cathode LiCoO₂ layer 303 in a thin film battery occurs by the way of grains or grain boundaries. Without being restricted in this disclosure to any particular theory of transport, it is believed that the grains with their planes parallel to substrate 302 will block the flow of Li ions while grains oriented with planes perpendicular to substrate 301 (i.e., oriented parallel to the direction of Li ion flow) facilitate the Li diffusion. Therefore, in order to provide a high-current battery structure, LiCoO₂ layer 303 should include crystals oriented in the <101> direction or <003> direction.

In accordance with the present invention, LiCoO₂ films can be deposited on substrate 302 with a pulsed-DC biased PVD system as was described above. In addition, an AKT 1600 PVD system can be modified to provide an RF bias, which is available in the Phoenix system, and an Advanced Energy Pinnacle plus 10K pulsed DC power supply can be utilized to provide power to a target. The pulsing frequency of the power supply-can vary from about 0 to about 350 KHz. The power output of the power supply is between 0 and about 10 kW. A target of densified LiCoO₂ tiles having a resistivity in the range of about 3 to about 10 kΩ can be utilized with dc-sputtering.

In some embodiments, LiCoO₂ films are deposited on Si wafers. Gas flows containing Oxygen and Argon can be utilized. In some embodiments, the Oxygen to Argon ratio ranges from 0 to about 50% with a total gas flow of about 80 sccm. The pulsing frequency ranges from about 200 kHz to about 300 kHz during deposition. RF bias can also be applied to the substrate. In many trials, the deposition rates vary from about 2 Angstrom/(kW sec) to about 1 Angstrom/(kW sec) depending on the O₂/Ar ratio as well as substrate bias.

Table I illustrates some example depositions of LiCoO₂ according to the present invention. XRD (x-Ray Diffraction) results taken on the resulting thin films illustrate that films deposited according to the present invention are crystalline films, often with highly textured grain sizes as large as about 150 nm. The dominant crystal orientation appears to be sensitive to the O₂/Ar ratio. For certain O₂/Ar ratios (∼10%), as-deposited films exhibit a preferred orientation in the <101> direction or the <003> direction with poorly developed <003> planes.

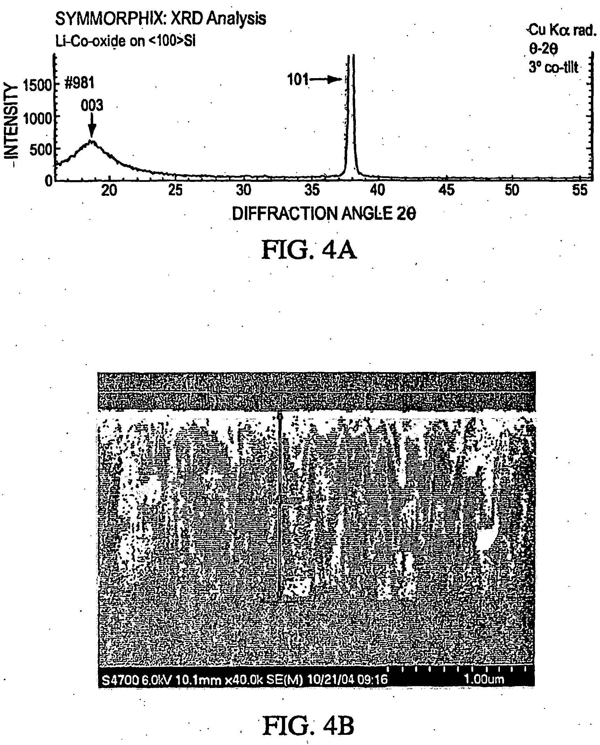

Figures 4A and 4B illustrate an XRD Analysis and SEM cross section, respectively, of the LiCoO₂ film deposited as Example 15 in Table I. Such a LiCoO₂ film was deposited on Si wafer with 2kW of target power, a frequency of 300 kHz, with 60 sccm Ar and 20 sccm of O₂ for a substrate with an initial temperature of about 30°C. As shown in the XRD analysis of Figure 4A, a strong <101> peak is indicated showing a strong orientation of LiCoO₂ crystals in the desired <101> crystallographic direction. The SEM cross section shown in Figure 4B further shows the columnar structure of the film having the <101> direction and the grain boundaries of the resulting LiCoO₂ crystals.

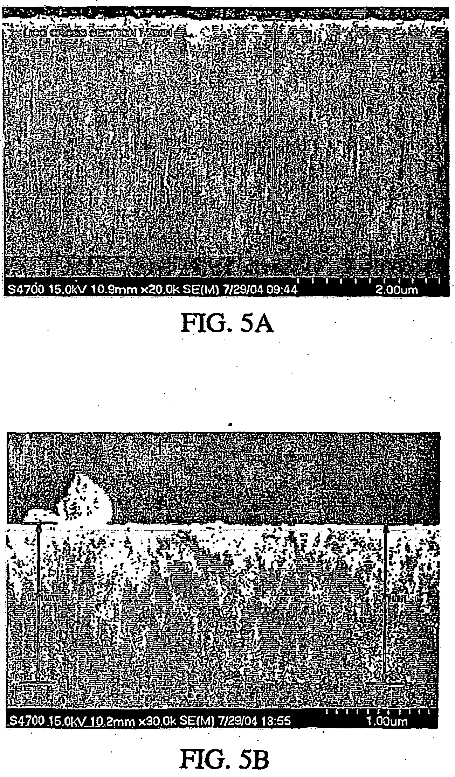

Figures 5A through 5F show SEM cross sections of further example depositions of LiCoO₂ crystals according to the present invention. In each of the examples, deposition of the-LiCoO₂ film was performed on a Si wafer with target power of about 2 kW and frequency of about 250 kHz. The LiCoO₂ film shown in Figure 5A corresponds to the example deposition Example 1 in Table I. In the deposition of the LiCoO₂ film shown in Figure 5A, no bias power was utilized with an argon flow rate of about 80 sccm and an oxygen flow rate of about 0 sccm. A deposition rate of about 1.45 µm/hr was achieved over the full substrate area of 400 X 500 mm. Further, as is indicated in the cross section shown in Figure 5A, a <101> orientation of the LiCoO₂ was achieved.

The rate of deposition of the LiCoO₂ layer shown in Figure 5A is very high, likely due to the relatively high conductivity or low resistivity of the ceramic LiCoO₂ oxide sputter target. A target resistance of 10 kOhms was measured by means of an Ohm meter over a distance of about 4 cm on the surface of target 12. This high rate allows the manufacture of the 3 micron or thicker LiCoO₂ layer required for the battery at high rate over a wide area in short times, resulting in very high productivity and very low cost Target resistance on the order of about 500 kΩ over the same distance by the same measurement technique or higher would not allow for such a high sputter efficiency or high rate of deposition at such a low target power. The resistance of conventional target materials can be unmeasurably high. A resistance of 100 kΩ over about 4 cm of surface will result in high sputter efficiency and high rate of deposition. Further, because deposition rates typically scale nearly linearly with target power, a deposition at 6 kW will yield a deposition rate of approximately 3 µm/hr, which is a very desirable rate of deposition for manufacturability of. Li-based thin-film solid-state batteries on a surface area of 400 X 500 mm².

The LiCoO₂ layer shown in Figure 5B is deposited under the conditions listed as Example 7 in Table I. Again, no bias was utilized in the deposition. An argon flow rate of about 72 sccm and an oxygen flow rate of about 8 sccm was utilized. The deposition rate was significantly reduced to about 0.85 µm/hr. Further, although a <101> crystallinity can be discerned, that <101> crystallinity is not as pronounced as that exhibited in the deposition of the film shown in Figure 5A.

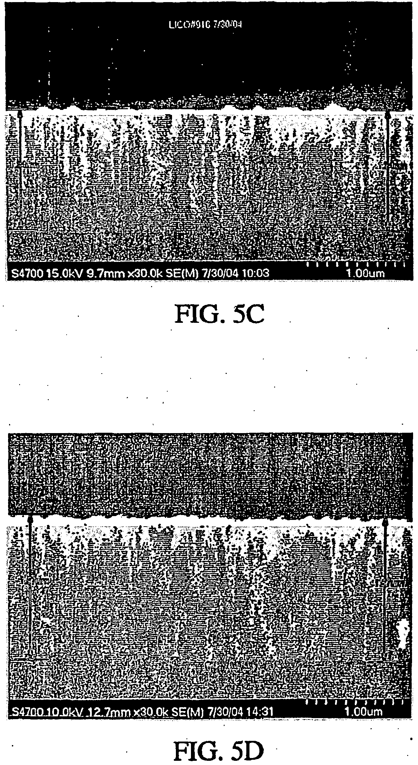

The LiCoO₂ film shown in Figure 5C was deposited according to Example 3 in Table I. In this deposition, 100 W of bias power is applied to the substrate. Further, an argon flow rate of 72 sccm, and an oxygen flow rate of 8 sccm was utilized. The deposition rate was about 0.67 µm/hr. Therefore, the application of bias in comparison with the LiCoO₂ film shown in Figure 5B further reduced the deposition rate (from 0.85 µm/hr of the example shown in Figure 5B to 0.67 µm/hr of the example shown in Figure 5C). Further, the desired <101> directionality of formed crystals appears to be further degraded.

The LiCoO₂ film shown in Figure 5D corresponds to Example 4 in Table I. In this deposition, the Ar/O₂ ratio was increased. As is shown in Figure 5D, increasing the Ar/O₂ ratio improves crystallinity. With respect to the example illustrated in Figure 5C, the deposition illustrated in Figure 5D was performed with an argon flow of about 76 sccm and an oxygen flow of about 4 sccm as well as retaining the 100 W bias to the substrate. The LiCoO₂ deposition rate was improved to 0.79 µm/hr from a rate of 0.67 µm/hr illustrated in Figure 5C.

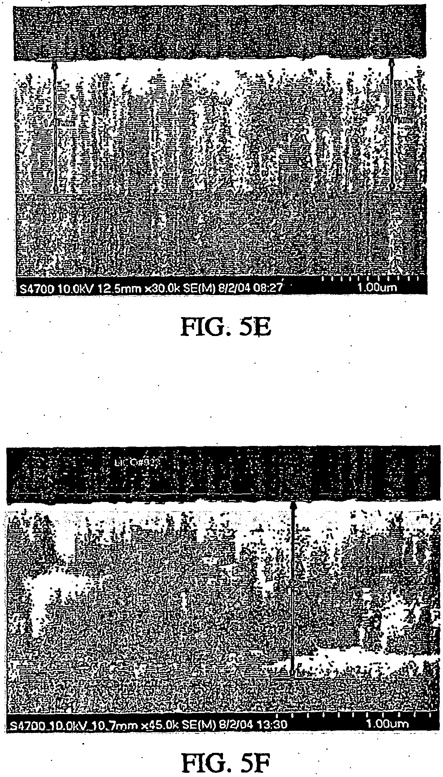

In the example deposition illustrated in Figure 5E corresponding to Example 5 in Table I. The substrate temperature was set at about 200°C while the bias power remained at about 100 W. The argon flow rate was set at about 76 seem and the oxygen flow rate was set at about 4 sccm. The resulting deposition rate for the LiCoO₂ layer was about 0.74 µm/hr.

In the example deposition illustrated in Figure 5F, which corresponds with Example 6 of Table I, the argon flow rate was set at about 74 sccm and the oxygen flow rate was set at about 6 sccm, resulting in a LiCoO₂ deposition rate of about 0.67 µm/hr. Therefore, increasing both argon and oxygen flow rate over the deposition illustrated in Figure 5E resulted in a lower deposition rate.

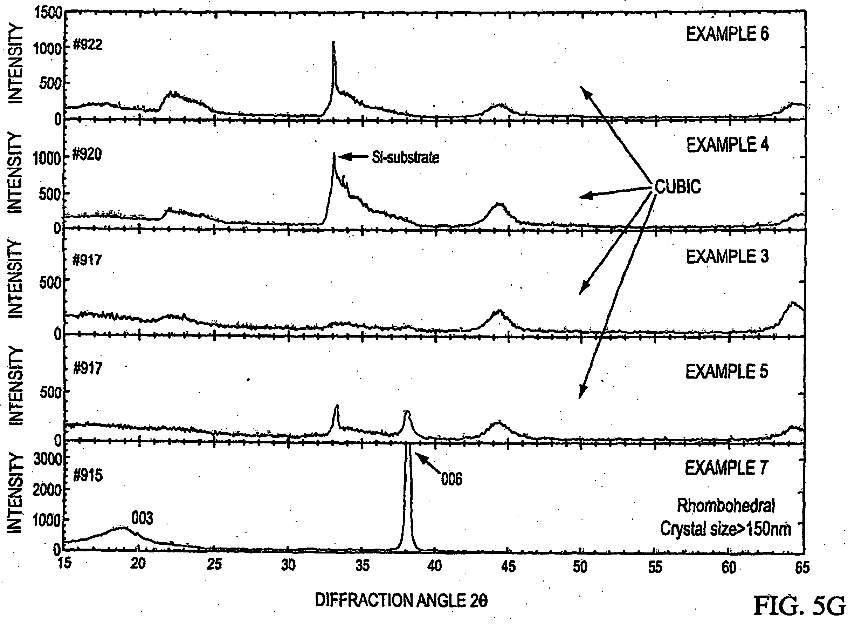

Figure 5G illustrates XRD data corresponding to Figures 5F, 5D, 5C, 5E, and 5B, respectively. As illustrated in Figure 5G, as-deposited crystalline LiCoO₂ is deposited in these processes.

The data show clearly that an as-deposited crystalline film of LiCoO₂ can be obtained under several of the process conditions, as shown in Table II. In particular, very high rates of deposition with low power are obtained along with the oriented crystalline structure for the process conditions according to embodiments of the present invention.

Figure 6A illustrates a layer of LiCoO₂ 602 deposited on a thin substrate 601 according to some embodiments of the present invention. Higher lithium-ion mobilities can be achieved utilizing crystalline LiCoO₂ cathode films 602 deposited on a thin substrate 601 that has thickness comparable to that of the battery stack itself, rather than a thickness many or tens of times that of the battery stack. Such a film can lead to faster charging and discharging rates. Substrate 601 can be formed of a thin metallic sheet (e.g., aluminum, titanium, stainless steel, or other suitable thin metallic sheet), can be formed of a polymer or plastic material, or may be formed of a ceramic or glass material. As shown in Figure 6B, if substrate 601 is an insulating material, a-conducting layer 603 can be deposited between substrate 601 and LiCoO₂ layer 602.

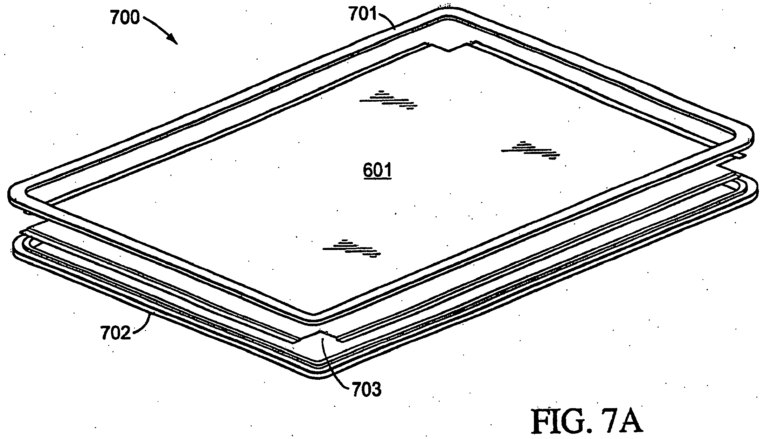

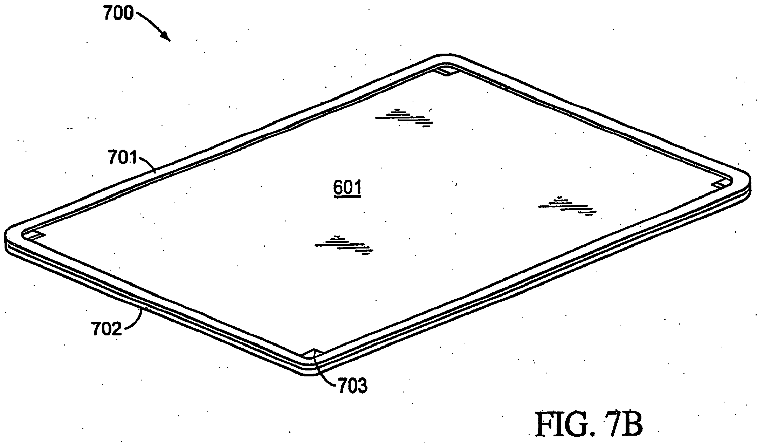

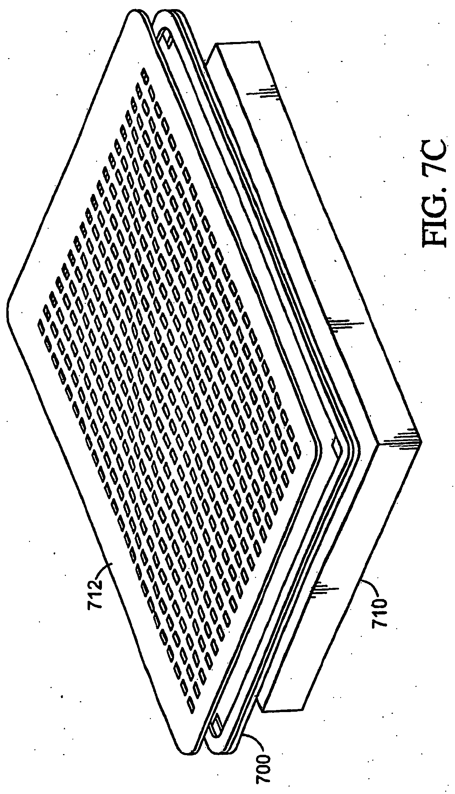

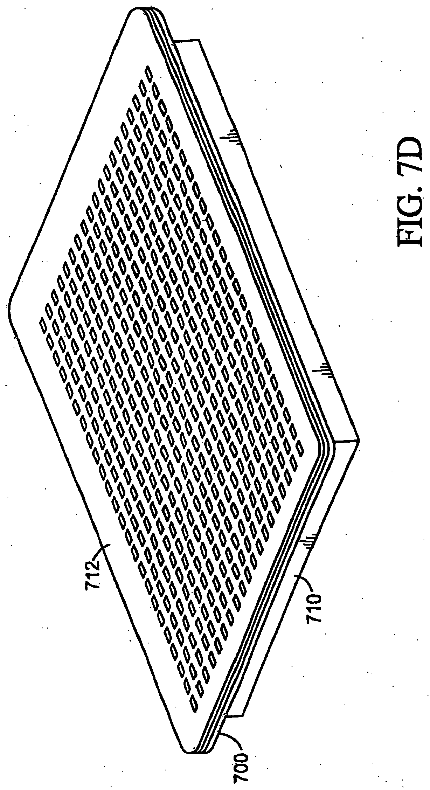

Depositing materials on a thin substrate involves holding and positioning the substrate during deposition. Figures 7A, 7B, 7C, and 7D illustrate a reusable fixture 700 for holding a thin film substrate. As shown in Figure 7A, reusable fixture 700 includes a top portion 701 and a bottom portion 702 that snap together. Thin substrate 601 is positioned between top portion 701 and bottom portion 702. As shown in Figure 7B, top portion 701 and bottom portion 702 are such that substrate 601 is brought into tension and subsequently clamped as top portion 701 is closed into bottom portion 702. Substrate 601 can be easily held by fixture 700 so that substrate 601 can be handled and positioned. In some embodiments, the corners of substrate 601, areas 703, are removed so that substrate 601 is more easily stretched by avoiding "wrap-around" corner clamping effects when top portion 701 is closed into bottom portion 702.

As shown in Figure 7C, a mask 712 can be attached to fixture 700. In some embodiments, fixture 700 includes guides in order to align fixture 700 with respect to mask 712. In some embodiments, mask 712 may be attached to fixture 700 and travel with fixture 700. Mask 712 can be positioned at any desired height above substrate 601 in fixture 700. Therefore, mask 712 can function as either a contact or proximity mask. In some embodiments, mask 712 is formed of another thin substrate mounted in a fixture similar to fixture 700.

As shown in Figure 7C and 7D, fixture 700 and mask 712 can be positioned relative to mount 710. Mount 710, for example, can be a susceptor, mount, or an electrostatic chuck of a processing chamber such as that shown in Figures 1A and 1B. Fixture 700 and mask 712 can have features that allow for ready alignment with respect to each others and with respect to mount 710. In some embodiments, mask 712 is resident in the processing chamber and aligned with fixture 700 during positioning of fixture 700 on mount 710, as shown in Figure 7D.

Utilizing fixture 700 as shown in Figures 7A, 7B, 7C, and 7D allows processing of a thin film substrate in a processing chamber. In some embodiments, thin film substrates can be about 10 µm or more. Further, thin film substrate 601, once mounted within fixture 700, can be handled and moved from process chamber to process chamber. Therefore, a multiprocessor chamber system can be utilized to form stacks of layers, including one or more layers of LiCoO₂ deposited according to embodiments of the present invention.

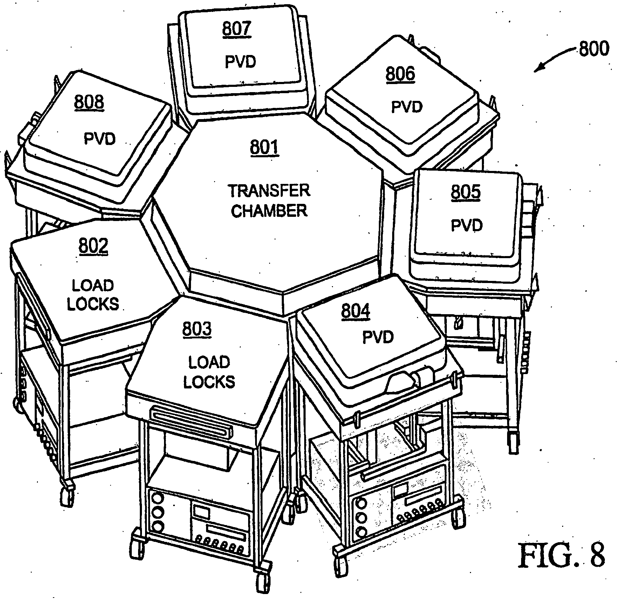

Figure 8 illustrates a cluster tool 800 for processing thin film substrates. Cluster tool 800 can, for example, include load lock 802 and load lock 803, through which mounted thin film substrate 601 is loaded and a resultant device is removed from cluster tool 800. Chambers 804, 805, 806, 807, and 808 are processing chambers for depositions of materials, heat treatments, etching, or other processes. One or more of chambers 804, 805, 806, 807, and 808 can be a pulsed-DC PVD chamber such as that discussed above with respect to Figures 1A and 1B and within which a LiCoO₂ film deposited according to embodiments of the present invention may be deposited.

Processing chambers 804, 805,806, 807, and 808 as well as load locks 802 and 803 are coupled by transfer chamber 801. Transfer chamber 801 includes substrate transfer robotics to shuttle individual wafers between processing chambers 804,805, 806, 807, and 808 and load locks 802 and 803.

In production of a conventional thin-film battery, ceramic substrates are loaded into load lock 803. A thin metallic layer can be deposited in chamber 804, followed by a LiCoO₂ deposition performed in chamber 805. The substrate is then removed through load lock 803 for an in-air heat treatment external to cluster tool 800. The treated wafer is then reloaded into cluster tool 800 through load lock 802. A LiPON layer can be deposited in chamber 806. The wafer is then again removed from cluster tool 800 for deposition of the lithium anode layer, or sometimes chamber 807 can be adapted to deposition of the lithium anode layer. A second metallic layer is deposited in chamber 808 to form a charge collector and anode collector. The finished battery structure is then off-loaded from cluster tool 800 in load lock 802. Wafers are shuttled from chamber to chamber by robotics in transfer chamber 801.

A battery structure produced according to the present invention could utilize thin film substrates loaded in a fixture such as fixture 700. Fixture 700 is then loaded into load lock 803. Chamber 804 may still include deposition of a conducting layer. Chamber 805 then includes deposition of a LiCoO₂ layer according to embodiments of the present invention. A LiPON layer can then be deposited in chamber 806. Chamber 807 may still be adapted to deposition of a lithium rich material such as lithium metal and chamber 808 can be utilized for deposition of the conducting layer of the current collector. In this process, no heat treatment is utilized to crystallize the LiCoO₂ layer.

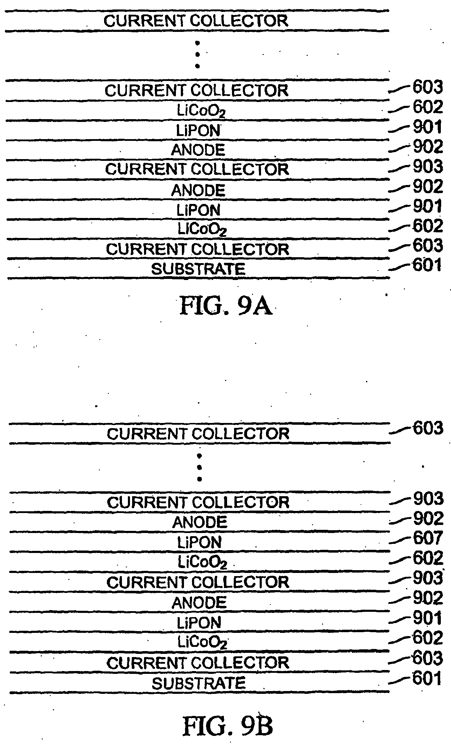

Another advantage of a thin film battery process is the ability to stack battery structures. In other words, substrates loaded into cluster tool 800 may traverse process chambers 804, 805, 806, 807, and 808 multiple times in order to produce multiply stacked battery structures. Figures 9A and 9B illustrate such battery structures.

Figure 9A illustrates a parallel coupled stacking. As shown in Figure 9A, a substrate 601, which for example can be a plastic substrate, is loaded into load lock 803. A conducting layer 603, for example about 2 µm of aluminum, copper, iridium or other material, acts as a bottom current collector. Conducting layer 603, for example, can be deposited in chamber 804. A LiCoO₂ layer 602 is then deposited on conducting layer 603. LiCoO₂ layer 602 can be about 3-10 µm and can be deposited in chamber 805 according to embodiments of the present invention. The wafer can then be moved to chamber 806 where a LiPON layer 901 of thickness of about .5 to about 2 µm can be deposited. In chamber 807, an anode layer 902, for example a lithium metal layer of up to about 10 µm, can then be deposited in chamber 807. A second conducting layer 903 can then be deposited over anode layer 902. A second battery stack can then be deposited over the first battery stack formed by metal layer 603, LiCoO2 layer 602, LiPON layer 901, lithium layer 902, and current collection conduction layer 903. Over current collection conducting layer 903, another lithium layer 902 is formed. Another LiPON layer 901 is formed over lithium layer 902. Another LiCoO2 layer 602 is formed over LiPON layer 901 and finally another metal layer 603 is formed over LiCoO2 layer 602. In some embodiments, further stackings can be formed. In some embodiments, metal layers 603 and 903 differ in the mask utilized in deposition so that tabs are formed for electrical coupling of layers.

As discussed above, any number of individual battery stacks can be formed such that parallel battery formations are formed. Such a parallel arrangment of battery stacking structure can be indicated as Current collector/LiCoO2/LiPON/Anode/current collector/Anode/LiPON/LiCoO2/current collector/LiCoO2 ... /current collector. Figure 9B illustrates an alternative stacking corresponding to the battery structure current collector/LiCoO2/LiPON/anode/current collector/LiCoO2/LiPON/anode/current collector... /current collector. In this case, a series arrangement battery stacking structure is formed because the individual battery stacks share anodes.

To form the structures shown in Figures 9A and 9B, substrates are rotated again through the chambers of cluster tool 800 in order to deposit the multiple sets of batteries. In general, a stack of any number of batteries can be deposited in this fashion.

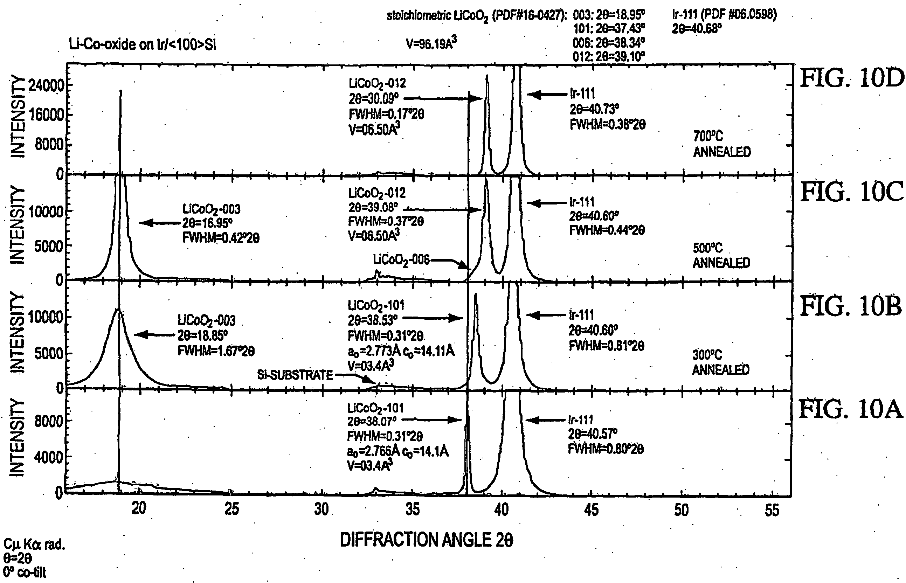

In some embodiments, stoichiometric LiCoO₂ can be deposited on iridium. Figures 10A through 10D illustrate an anneal procedure for Li-Co deposition over an iridium layer that has been deposited on a Si wafer. The LiCoO₂ deposition was accomplished as discussed above with a target power of 2 kW, no bias power, reverse time of 1.6 µs, a pulsing frequency of 300 kHz, with 60 sccm Ar flow and 20 sccm of O₂ flow, with no pre-heat for 7200 sec. AS a result, a layer of LiCoO₂ of about 1.51 µm was deposited.

Figures 10A through 10D show XRD analysis of both as-deposited and annealed layers of LiCoO₂ deposited as discussed above. The XRD analysis of the as-deposited layer demonstrates a shallow peak art 2θ = 18.85° denoting a <003> orientation of crystalline LiCoO₂, a sharper peak at about 2θ = 38.07° corresponding with the desired <101> crystallographic direction, and a peak at 2θ = 40.57° corresponding to the <111> direction of iridium. However, the position of the <101> LiCoO₂ peak indicates that the <101 > LiCoO₂ peak is nonstoichiometric LiCoO₂. In order to be useful as a battery layer, stoichiometric LiCoO₂ provides for the best Li transport. One of ordinary skill in the art will notice that careful adjustment of deposition parameters can provide stoichiometric LiCoO₂ of desired orientation.

Figure 10B shows an XRD analysis of the sample shown in figure 10A after a 300°C anneal in air for 2 hours. As shown in Figure 10B, the XRD peak corresponding to <003> LiCoO₂ grows, indicating crystallization of LiCoO₂ into the <003> direction. Further, the <101> peak of LiCoO₂ shifts slightly to 2θ = 38.53°, indicating a more stoichiometric crystallization of the <101> LiCoO₂. However, the crystalline LiCoO₂ is still not stoichiometric after this anneal. One of ordinary skill in the art will notice that longer anneals and/or further adjustment of the deposited stoichiometry may result in usefully oriented stoichiometric LiCoO₂ layers with anneal temperatures at 300°C or less. Consequently, low temperature materials such as polymers, glass, or metal may be utilized as the substrate.

Figure 10C illustrates an XRD analysis from the sample after a subsequent 500°C anneal in air for 2 hours. As shown in Figure 10C, more of the LiCoO₂ crystallizes into the <003> layer. Further, the <101> LiCoO₂ peak shifts again to 20 = 39.08°, indicating crystallization of a <012> layer of LiCoO₂. In this case, the <012> LiCoO₂ cyrstal is stoichiometric and therefore allows for efficient Li transport. One of ordinary skill in the art will notice that longer anneals and/or further adjustment of the deposited stoichiometry may result in usefully oriented stoichiometric LiCoO₂ layers with anneal temperatures at 500°C or less. Consequently, low temperature materials such as polymers, glass, or metal may be utilized as the substrate.

Figure 10D illustrates an XRD analsysis of the sample after a subsequent anneal of 700°C in air for 2 hours. As shown in Figure 10D, the <003> LiCoO₂ peak disappears, but the <012> LiCoO₂ peak remains relatively the same as that shown in the 500° anneal illustrated in Figure 10C.

Figures 10A through 10D demonstrate deposition of <101> LiCoO₂ at low temperature over an iridium layer. Subsequent anneals to 500°C may be desired to change the stoichiometry of the <101> LiCoO₂ layer, but anneals to 700 °C do not appear to be necessary. With anneal temperatures less than 500°C, depositions of a LiCoO₂ layer over a conducting iridium layer can be accomplished on glass, aluminum foil, plastic, or other low temperature substrate material. Anneal temperatures of less than 500°C but greater than 300°C or lengthening the time of lower temperature anneals may also result in desired orientations of stoichiometric crystalline LiCoO₂.

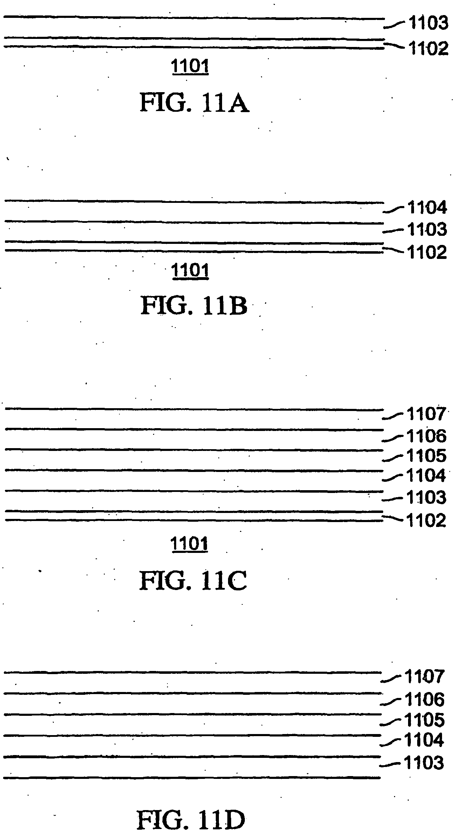

Figures 11A through 11D illustrate formation of a single-layer battery according to some embodiments of the present invention. As shown in Figure 11A, a lift-off layer 1102 can be deposited on a substrate 1101. Further, an iridium layer 1103 can be deposited over lift-off layer 1102. In some embodiments, substrate 1101 can be plastic, glass, Al foil, Si wafer, or any other material. Lift-off layer 1102 can be any lift off layer and can be a polymer layer such as polyimide, an inorganic layer such as CaF₂ or carbon, or an adhesive layer that loses its adhesion as a result of, for example, oxidation, heat, or light. Lift-off layers are well known. Iridium layer 1103 can be from about 500 Å or more.

As shown in Figure 11 B, a LiCoO₂ layer is deposited over iridium layer 1103 as was discussed above. In some embodiments, an anneal can be performed at this step. In some embodiments, further layers of the battery may be deposited before an anneal step is performed. In some embodiments, a stoichiometric LiCoO₂ layer of a useful crystalline orientation may result in the as-deposited LiCoO₂ with no further anneals necessary.

Figure 11C illustrates deposition of a LiPON layer 1105 over the LiCoO₂ layer, deposition of a Li layer 1106 over LiPON layer 1105, and deposition of an electrode layer 1107 over Li layer 1106. In some embodiments, an anneal step of up to 500°C as discussed above may be performed here.

As shown in Figure 11D, the resulting single-layer battery formed from iridium layer 1103, LiCoO₂ layer 1104, LiPON layer 1105, Li layer 1106, and electrode layer 1107 can be "lifted off" from substrate 1101. Such a single-layer battery can be a freestanding battery of thickness about 5 µm or greater. Such a battery, without the requirement of a substrate 1101, is well known to have the potential of energy storage of greater than about 1 kW-hr/liter.

As an alternative to a lift-off process as described in Figures 11A through 11D, a substrate may be removed during anneal leaving a single-layer battery. Further, in some embodiments, substrate 1101 can be removed by a solvent, etching, or a photo process. Further, single-layer batteries may be combined or stacked in any fashion to provide a device of greater energy storage at a particular voltage.

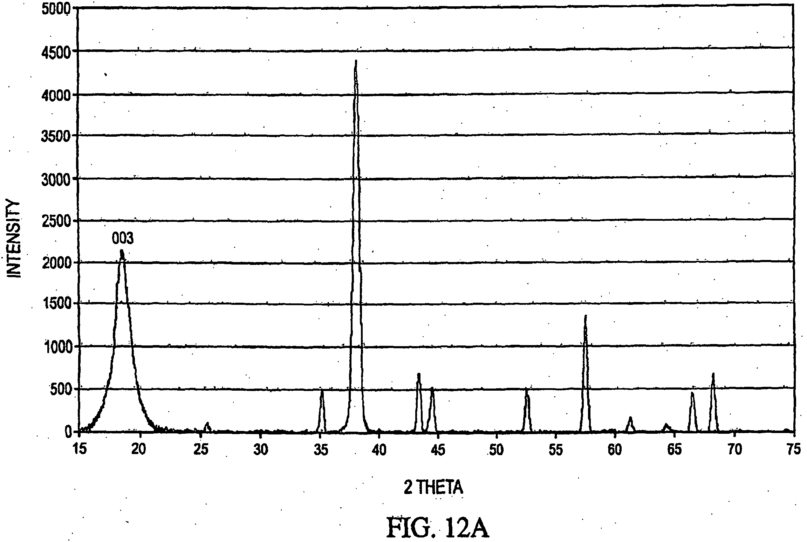

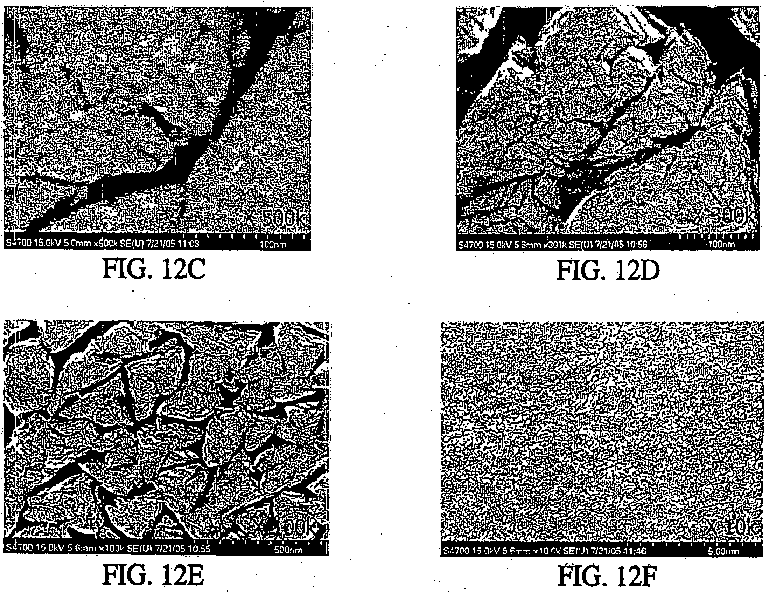

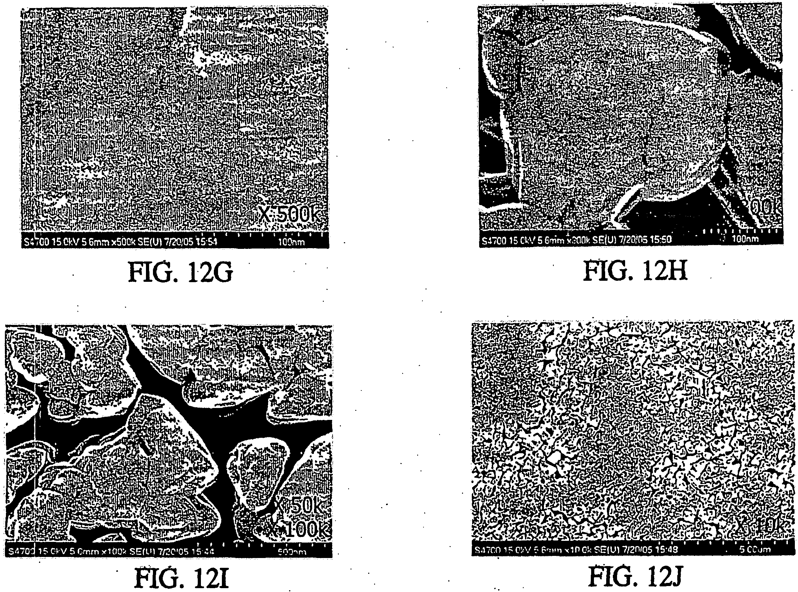

Figures 12A through 12L illustrate the crystallinity of as-grown and post anneal LiCoO₂ layers according to samples 31 and 32 illustrated in Table I. Samples 31 and 32 were formed in the same deposition, utilizing a silicon substrate and an alumina substrate, respectively.

Figure 12A illustrates an XRD analysis of the as-deposited LiCoO₂ film on Al₂O₃ substrate (Example 32 in Table I). A broad <003> crystalline LiCoO₂ peak is observed. The remaining peaks in the analysis, which are not labeled in Figure 12A, result from the Al₂O₃ substrate. The <003> peak is characteristic of the layered structure in the as-deposited crystalline LiCoO₂ film according to embodiments of the present invention.

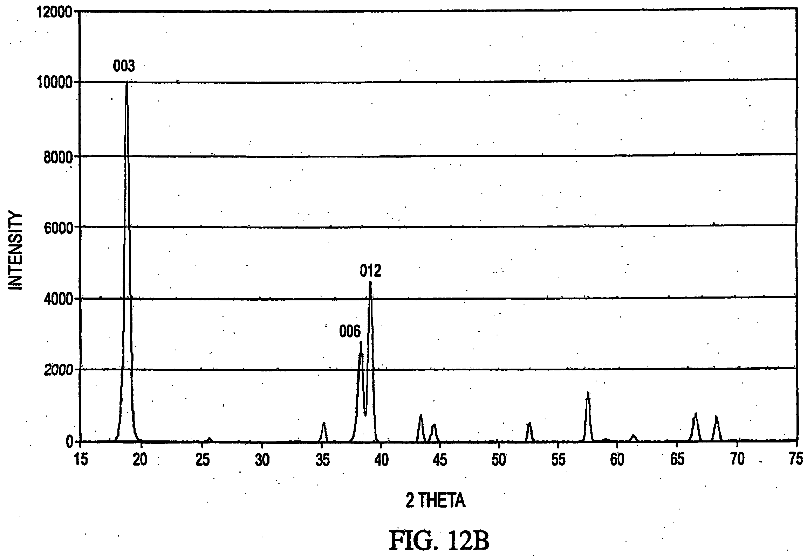

Figure 12B illustrates the crystallinity of the LiCoO2 film shown in Figure 12A after a 2 hr 700 °C anneal. As shown in Figure 12B, the <003> peak becomes sharper and higher, indicating better crystallinity. As shown in Figures 12G through 12J, in comparison with figures 12C through 12F, the columnar structure ripens with the anneal and the grain size becomes larger with anneal. Figure 12B also shows <012> and <006> crystallinity peaks.

Figure 12C through 12F show SEM photos of the granularity of the as-deposited film corresponding to Example 32 in Figure I. Figures 12G through 12J show SEM photos of the granularity of the annealed film, as illustrated in Figure 12B. A comparison of Figures 12C through 12F with 12G through 12J illustrate the increased granularity resulting from the anneal process.

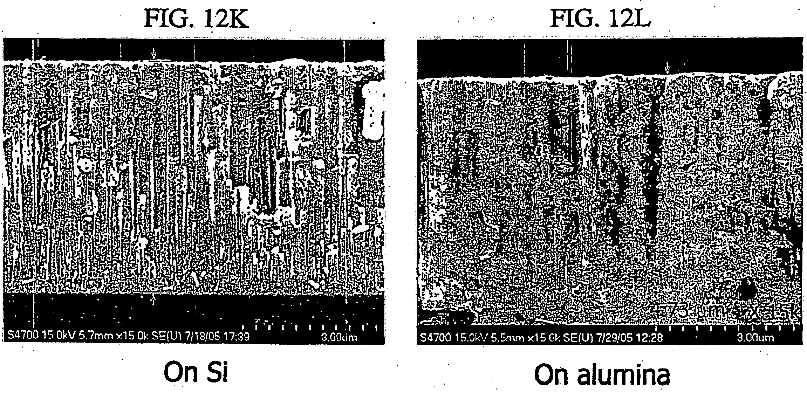

Figure 12K illustrates a fracture cross-section SEM that illustrates the morphology of the as-deposited crystalline film corresponding to Example 31 in Table I. Figure 12L illustrate a similar cross-section SEM corresponding to the film grown according to Example 32 in Table I.

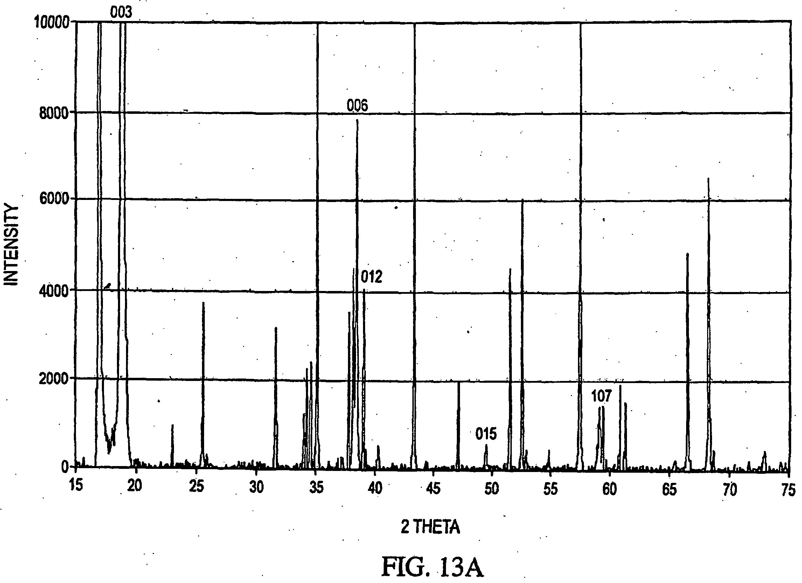

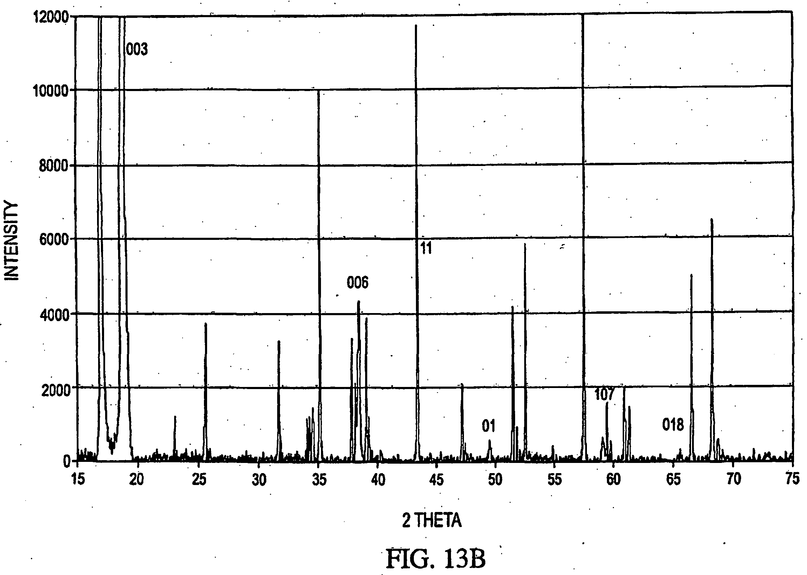

Figures 13A through 13J illustrate rapid thermal anneal processes applied to a LiCoO₂ layer as in Example 49 of Table I. In that example, LiCoO₂ is deposited on alumina with a 2 kW pulsed DC power with no bias. Argon flow as set to 60 sccm and oxygen flow was set to 20 sccm. The deposition parameters are nearly identical with those of Example 32 in Table I, therefore XRD data for the as-deposited films are shown in Figure 12A. Figure 13A shows XRD data after a 15 minute 700 °C anneal in an argon atmosphere. Ramp-up time (room temperature to 700 °C) is 45 sec and ramp-down time (700 °C to about 300 °C) occurred over 10 min. At 300 °C, the sample is removed from the rapid-thermal-anneal (RTA) oven and cooled in air to room temperature. As shown in Figure 13A, substantial crystallinity is obtained. Figure 13B shows XRD data after a RTA as described with Figure 13A in an argon/oxygen atmosphere. The argon/oxygen ratio was 3:1.

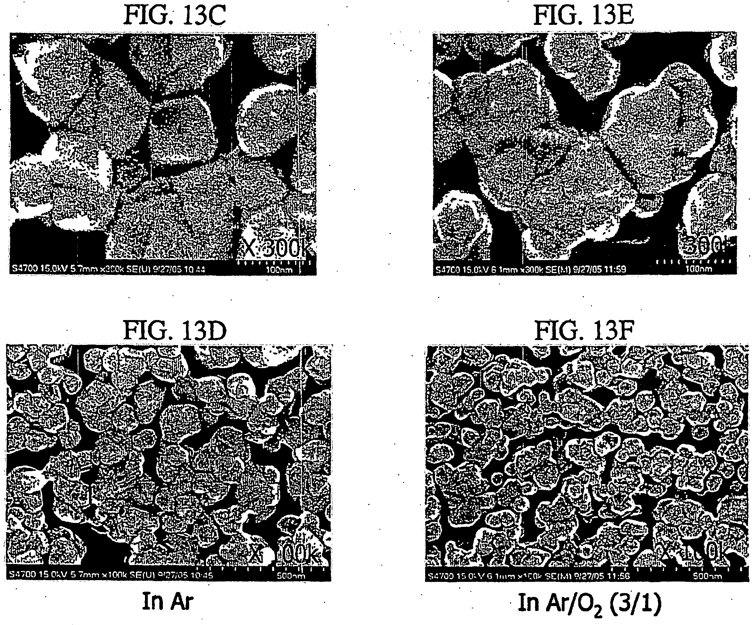

As shown in a comparison of Figures 13A and 13B, more crystallinity is observed in an argon only RTA than with a RTA performed in the presence of oxygen. This is further illustrated in a comparison of Figures 13C and 13D with Figures 13E and 13F. Figures 13C and 13D show the granularity of the LiCoO₂ film after the RTA illustrated in Figure 13A. Figures 13E and 13F show the granularity of the LiCoO₂ film after the RTA illustrated in Figure 13B. As is observed, the granularity shown in Figures 13C and 13D (which differ in magnification) is better than that shown in Figures 13E and 13F (which also differ in magnification).

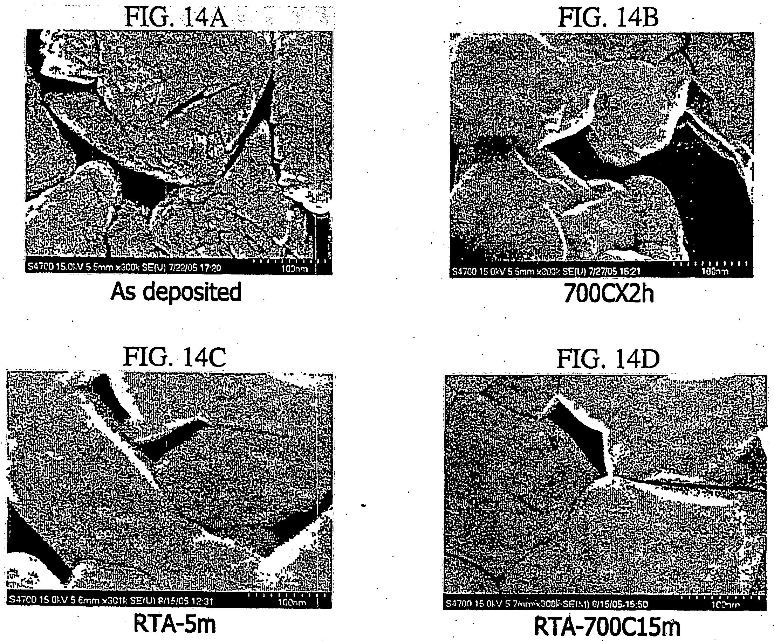

Figures 14A through 14D illustrate several anneal processes with the Example 37 of Table I. In that example, LiCoO2 was deposited on alumina utilizing a pulsed-dc process with 2kW of power and 100 W of bias with an argon flow of 60 sccm and an oxygen flow of 20 sccm.

Figure 14A shows an SEM photo of an as-deposited LiCoO₂ film according to the process illustrated in Example 37 of Table I. Figure 14B shows an SEM photo of LiCoO₂ film according to the process illustrated in Example 37 of Table I, annealed conventionally with a two-hour 700 °C anneal. Figures 14C and 14D show SEM photos of a LiCoO₂ film according to the process illustrated in Example 37 of Table I, annealed in an RTA process at 700 °C. The ramp-up and ramp-down times in the RTA process is illustrated above. Figure 14C shows an SEM photo of a LiCoO₂ film after an RTA process at 700 °C for five minutes whereas Figure 14D shows an SEM photo of a LiCoO₂ film after an RTA process at 700 °C for fifteen minutes. It is clear from a comparison of Figures 14C and 14D with Figure 14B, that much better granularity is achieved with the low thermal-budget RTA process rather than the conventional furnace anneal. A low thermal-budget RTA process allows for deposition of such films on low temperature substrates.

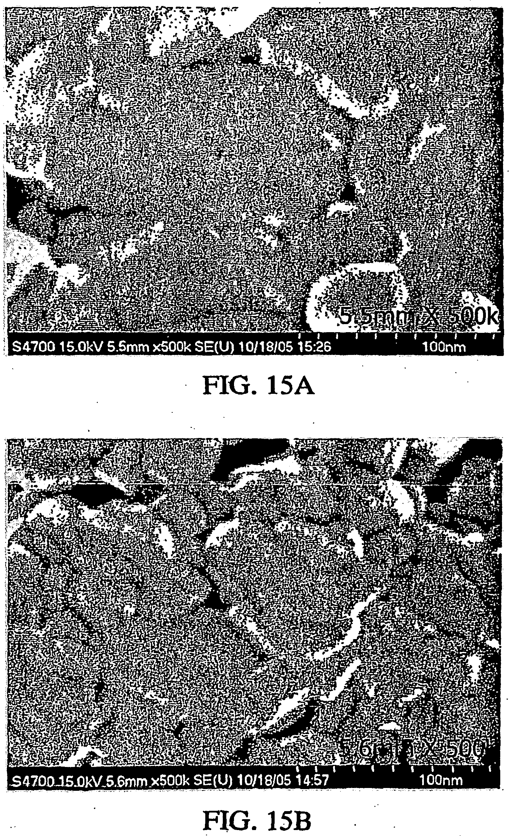

Figures 15A and 15B show SEM photos of a LiCoO₂ film that was annealed in an RTA process utilizing two different ramp-up times, illustrating the effects of the ramp time in the RTA process. A LiCoO₂ film was deposited on an alumina substrate according to the process described as Example 51 in Table I. The film shown in Figure 15A was annealed with a 45 sec ramp-up time (i.e., room temperature to 700 °C in 45 sec). The film shown in Figure 15B was annealed with a 240 sec ramp-up time. Both films were held at 700 °C for five minutes. As shown in a comparison between Figures 15A and 15B, it is clear that a short anneal ramp-up times yield better granularity than longer ramp-up times.

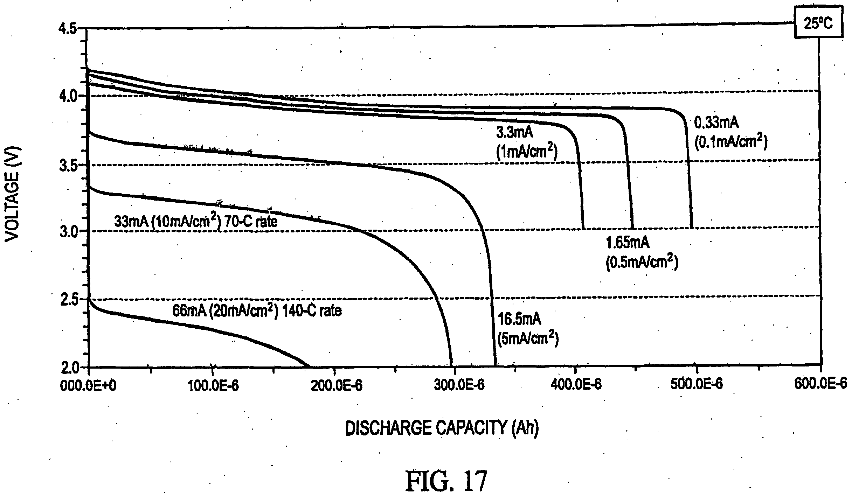

Figure 17 illustrates battery charge and discharge profiles of a battery structure formed utilizing LiCoO₂ films according to embodiments of the present invention. The LiCoO₂ film in the battery profiled in Figure 17 was deposited according to Example 54 in Table I. The LiCoO₂ film was deposited on an alumina substrate with a gold current collector. The LiCoO₂ film was annealed utilizing a fast-ramp (45 sec) RTA process as was described above. A 1.5 µm LiPON layer was then deposited with a standard RF deposition process without bias in a modified AKT reactor. A lithium anode and a nickel current collector were then deposited. Data was taken at 0.33 mA, 1.65 mA, 3.3 mA, 16.5 mA, 33 mA, and 66 mA. As observed, the battery was capable of storing an exceptional 25 mA/cm² at voltages greater than 2.0 V.

One skilled in the art will recognize variations and modifications of the examples specifically discussed in this disclosure. These variations and modifications are intended to be within the scope of this disclosure. As such, the scope is limited only by the following claims.

**TABLE I**

| Example # | Target Power (kW) | Bias Power (W) | Reverse Time (µs) | Frequency (kHz) | Ar (sccm) | O₂ (sccm) | Initial Substrate Temperature (temperature during deposit) (°C) | Deposition Time (sec) | Film Thickness (µm) |
|---|---|---|---|---|---|---|---|---|---|
| 1 | 2 | 0 | 1,6 | 250 | 80 | 0 | 30 | 10000 | 3.9 |
| 2 | 2 | 0 | | 250 | 72 | 8 | 30 | 7200 | 1.7 |
| 3 | 2 | 100 | | 250 | 72 | 8 | 30 | 7200 | 1.34 |
| 4 | 2 | 100 | | 250 | 76 | 4 | 30 | 7200 | 1.57 |
| 5 | 2 | 100 | | 250 | 76 | 4 | 200 | 7200 | 1.3 |
| 6 | 2 | 100 | | 250 | 74 | 6 | 200 | 7200 | 1.3 |
| 7 | 2 | 0 | | 300 | 72 | 8 | 30 | 7200 | 1.58 |
| 8 | 2 | 0 | | 300 | 74 | 6 | 30 | 7200 | |
| 9 | 2 | 100 | | 300 | 74 | 6 | 30 | 7200 | |
| 10 | 2 | 100 | | 300 | 72 | 8 | 30 | 7200 | |
| 11 | 2 | 100 | | 300 | 70 | 10 | 30 | 7200 | |
| 12 | 2 | 0 | | 300 | 70 | 10 | 30 | 7200 | |
| 13 | 2 | 0 | | 300 | 72 | 8 | 30 | 7200 | 1.58 |
| 14 | 2 | 0 | 300 | 300 | 74 | 6 | 30 | 7200 | |
| 15 | 2 | 0 | | 300 | 60 | 20 | 30 | 7200 | |
| 16 | 2 | 0 | | 300 | 50 | 30 | 30 | 7200 | |
| 17 | 2 | 200 | | 300 | 60 | 20 | 30 | 7200 | |
| 18 | 2 | 50 | | 300 | 60 | 20 | 30 | 7200 | |
| 19 | 2 | 0 | | 300 | 70 | 10 | 30 | 7200 | |
| 20 | 2 | 0 | | 300 | 65 | 15 | 30 | 7200 | |
| 21 | 3 | 0 | | 300 | 65 | 15 | 30 | 7200 | |
| 22 | 2 | 0 | 1.6 | 250 | 60 | 20 | 30 | 7200 | |
| 23 | 3 | 0 | 1.6 | 250 | 60 | 20 | 30 | 7200 | |
| 24 | 2 | 0 | 1.6 | 250 | 60 | 20 | 30 (NPH) | 7200 | |
| 25 | 2 | 0 | 1.6 | 250 | 60 | 20 | 10min heat 30min coc | 7200 | |
| 26 | 2 | 0 | 1.6 | 250 | 60 | 20 | no preheat | 9000 | |
| 27 | 2 | 0 | | 300 | 60 | 20 | no preheat | 7200 | |
| 28 | 2 | 0 | | 300 | 60 | 20 | 15min heat, 10min | 7200 | |
| 29 | 2 | 0 | | 250 | 60 | 20 | no preheat | | |
| 30 | 2 | 0 | | 250 | 60 | 20 | 10min, 10min | | |
| 31 | 2 | 0 | 1.3 | 300 | 60 | 20 | 30 (220) | 7200 | 4.81 |
| 32 | 2 | 0 | 1.3 | 300 | 60 | 20 | 30 (220) | 7200 | 4.74 |
| 33 | 2 | 0 | 1.3 | 300 | 22.5 | 7.5 | 30 (220) | 7200 | 3.99 |
| 34 | 2 | 0 | 1.3 | 300 | 22.5 | 7.5 | 30 (220) | 7200 | 3.93 |
| 35 | 2 | 0 | 1.3 | 300 | 37.5 | 12.5 | 30 (220) | 7200 | 3.64 |
| 36 | 2 | 0 | 1.3 | 300 | 37.5 | 12.5 | 30 (220) | 7200 | 3.54 |
| 37 | 2 | 100 | 1.3 | 300 | 60 | 20 | 30 (220) | 7200 | 4.54 |
| 38 | 2 | 200 | 1.3 | 300 | 60 | 20 | 30 (220) | 7200 | 4.84 |
| 39 | 2 | 100 | 1.3 | 300 | 37.5 | 12.5 | 30 (220) | 7200 | 4.30 |
| 40 | 2 | 100 | 1.3 | 300 | 22.5 | 7.5 | 30 (220) | 7200 | 3.77 |
| 41 | 2 | 200 | 1.3 | 300 | 37.5 | 12.5 | 30 (220) | 7200 | 3.92 |
| 42 | 2 | 200 | 1.3 | 300 | 60 | 20 | 400 | 7200 | 3.77 |
| 43 | 2 | 0 | 1.3 | 300 | 22.5 | 7.5 | 30(220) | 7200 | 3.24 |
| 44 | 2 | 0 | 1.3 | 300 | 60 | 20 | 30(220) | 7200 | 3.88 |
| 45 | 2 | 0 | 1.3 | 300 | 60 | 20 | 30(220) | 3600 | 1.78 |
| 46 | 2 | 200 | 1.3 | 300 | 60 | 20 | 30(220) | 3600 | 1.87 |
| 47 | 2 | 200 | 1.3 | 300 | 22.5 | 7.5 | 30(220) | 3600 | 1.52 |
| 48 | 2 | 0 | 1.3 | 300 | 60 | 20 | 30(220) | 6000 | 1.12 |
| 49 | 2 | 0 | 1.3 | 300 | 60 | 20 | 30(220) | 10800 | 1.89 |
| 50 | 2 | 0 | 1.3 | 300 | 60 | 20 | 30(220) | 14400 | 2.52 |
| 51 | 2 | 100 | 1.3 | 300 | 60 | 20 | 30(220) | 10000 | 1.57 |
| 52 | 2 | 100 | 1.3 | 300 | 60 | 20 | 30(220) | 10000 | 2.11 |
| 53 | 2 | 100 | 1.3 | 300 | 60 | 20 | 30(220) | 6000 | 2.70 |
| 54 | 2 | 100 | | 300 | 60 | 20 | 30(220) | 6000 | 2.70 |

**TABLE II**

| Example # | Phase | Lattice | Texture | d₁₀₁ [Å] | 2θ [°] | crystallite size [Å] |
|---|---|---|---|---|---|---|
| 15 | LiCoO₂ | rhombohedral | strong [101] | 2.376(1) | 37.83 | ∼1300 |
| 16 | LiCoO₂ | Rhombohedral | strong [101] | 2.375(1) | 37.85 | ∼750 |
| 17 | Co | cubic | random | -- | -- | <50 |
| 18 | Co | cubic | random | -- | -- | <50 |
| 19 | LiCoO₂ | rhombohedral | strong [101] | 2.370(1) | 37.93 | ∼1400 |
| 20 | LiCoO₂ | rhombohedral | strong [101] | 2.372(1) | 37.90 | -1500 |
| 21 | LiCoO₂ | rhombohedral | strong [101] | 2.370(1) | 37.92 | ∼1700 |
| PDF | LiCoO₂ | Rhombohedral | random | 2.408(1) | 37.31 | -- |

## Claims

1. A method of depositing a LiCoO₂ layer, comprising:
placing a substrate in a reactor;
flowing at least an inert gas through the reactor;
applying pulsed DC power to a sputter target comprising LiCoO₂ ;
positioning said target opposite said substrate;
forming a layer of LiCoO₂ over said substrate; and
applying rapid thermal annealing to said substrate and LiCoO₂ layer,
wherein said rapid thermal annealing process further comprises annealing said LiCoO₂ layer to a temperature of about 700°C for a period of time of less than about 10 minutes.

2. The method of claim 1, wherein said rapid thermal annealing step is performed at a sufficiently low temperature in conjunction with a sufficiently short period of time thus providing a sufficiently low thermal budget, which is applied to low temperature substrate material.

3. The method of claim 1, wherein said substrate comprises, at least in a part, a material selected form the group of silicon, polymers, glasses, ceramics, stainless steel, and metals.

4. The method of claim 1, further comprising depositing a platinum layer on said substrate.

5. The method of claims 1, further comprising depositing an electrically conducting layer on the substrate.

6. The method of claim 1, further comprising applying a RF bias to said substrate while applying pulsed DC power to said sputter target.

7. The method of claim 1, wherein said LiCoO₂ layer comprises, at least in part, a crystalline structure.

8. The method of claim 1, wherein said LiCoO₂ layer comprises, at least in part, a crystalline structure and a preferred crystallographic orientation in the (101) plane.

9. The method of claim 1, wherein said LiCoO₂ layer comprises, at least in a part, a crystalline structure and a preferred crystallographic orientation in the (003) plane.

10. The method of claim 1, wherein said LiCoO₂ layer comprises a grain size of between about 750 Å and about 1700 Å.

11. The method of claim 7, further comprising preheating said substrate to a temperature of about 200°C prior to depositing said LiCoO₂ layer.

12. The method of claim 1, wherein said LiCoO₂ layer is a crystalline layer deposited without crystallizing heat treatment.

13. The method of claim 1, further comprising depositing an oxide layer on said substrate.

14. The method of claim 13, wherein said oxide layer comprises a silicon dioxide layer.

15. The method of claim 1, further comprising depositing said LiCoO₂ layer at a rate greater than about 1 µm per hour.

16. The method of claim 1 wherein said sputter target further comprises a material selected from the group of Ni, Si, Nb or other suitable metal oxides.

17. The method of claim 1 wherein said sputter target comprises a ceramic LiCoO₂ sputter target with a resistance measured across about 4 cm of its surface of less than about 500 kΩ.

18. A method of producing a battery, comprising:
providing a first conductor;
depositing a LiCoO₂ layer over said first conductor according to any of claims 1 to 16, including providing pulsed DC power to a sputter target while providing RF bias power to a substrate that is positioned opposite the sputter target;
rapid thermal annealing said LiCoO₂ layer at a temperature of about 700°C for a period of time of less than about 10 min to increase its grain size of the crystalline layer to between about 750 Å and about 1700 Å;
depositing an electrolyte layer over said LiCoO₂ layer; and
depositing an electrochemically active conductor over said electrolyte layer.

## Patentansprüche

1. Verfahren zum Auftragen einer LiCoO₂-Schicht, umfassend:
Platzieren eines Substrats in einem Reaktor;
Strömen zumindest eines inerten Gases durch den Reaktor;
Anwenden pulsierten Gleichstroms auf ein Sputtertarget umfassend LiCoO₂;
Positionieren des Targets gegenüber des Substrats;
Bildung einer Schicht von LiCoO₂ über dem Substrat; und
Anwenden von zügiger thermischer Glühung (rapid thermal annealing) auf das Substrat und die LiCoO₂-Schicht;
wobei das zügige thermische Glühungs-Verfahren des Weiteren die Glühung der LiCoO₂-Schicht auf eine Temperatur von ungefähr 700°C. für eine Zeit von weniger als ungefähr 10 Minuten umfasst.

2. Verfahren nach Anspruch 1, wobei der zügige thermische Glühungs-Schritt bei einer ausreichend niedrigen Temperatur in Kombination mit einer ausreichend kurzen Zeitdauer durchgeführt wird, was einen ausreichend niedrigen Wärmeumsatz bereitstellt, der auf das niedrige Temperatur-Substratmaterial angewandt wird.

3. Verfahren nach Anspruch 1, wobei das Substrat, zumindest in einem Teil, ein Material ausgewählt aus der Gruppe von Silikon, Polymeren, Gläsern, Keramiken, rostfreiem Stahl und Metalle umfasst.

4. Verfahren nach Anspruch 1, des Weiteren umfassend das Aufbringen einer Platinschicht auf das Substrat.

5. Verfahren nach Anspruch 1, des Weiteren umfassend das Aufbringen einer elektrisch leitenden Schicht auf das Substrat.

6. Verfahren nach Anspruch 1, des Weiteren umfassend das Anwenden einer HF Vorspannung auf das Substrat während pulsierter Gleichstrom auf das Sputtertarget angewandt wird.

7. Verfahren nach Anspruch 1, wobei die LiCoO₂-Schicht zumindest teilweise eine kristalline Struktur umfasst.

8. Verfahren nach Anspruch 1, wobei die LiCoO₂-Schicht zumindest teilweise eine kristalline Struktur und eine bevorzugte kristallographische Orientierung in der (101) Ebene umfasst.

9. Verfahren nach Anspruch 1, wobei die LiCoO₂-Schicht zumindest teilweise eine kristalline Struktur und eine bevorzugte kristallographische Orientierung in der (003) Ebene umfasst.

10. Verfahren nach Anspruch 1, wobei die LiCoO₂-Schicht eine Korngröße von zwischen ungefähr 750 Å und ungefähr 1700 Å umfasst.

11. Verfahren nach Anspruch 7, des Weiteren umfassend das Vorwärmen des Substrats auf eine Temperatur von ungefähr 200 °C vor der Aufbringung der LiCoO₂-Schicht.

12. Verfahren nach Anspruch 1, wobei die LiCoO₂-Schicht eine kristalline Schicht ist, die ohne kristallisierende Wärmebehandlung aufgebracht wird.

13. Verfahren nach Anspruch 1, des Weiteren umfassend das Aufbringen einer Oxidschicht auf das Substrat.

14. Verfahren nach Anspruch 13, wobei die Oxidschicht eine Silikondioxid-Schicht umfasst.

15. Verfahren nach Anspruch 1, des Weiteren umfassend das Aufbringen der LiCoO₂-Schicht bei einem Rate von mehr als ungefähr 1 µm pro Stunde.

16. Verfahren nach Anspruch 1, wobei das Sputtertarget des Weiteren ein Material umfasst ausgewählt aus der Gruppe von Ni, Si, Nb oder anderer geeigneter Metalloxide.

17. Verfahren nach Anspruch 1, wobei das Sputtertarget ein keramisches LiCoO₂-Sputtertarget mit einem Widerstand gemessen über ungefähr 4 cm seiner Oberfläche von weniger als ungefähr 500 kΩ umfasst.

18. Verfahren der Herstellung einer Batterie umfassend:
Bereitstellen eines ersten Leiters;
Aufbringen einer LiCoO₂-Schicht über den ersten Leiter gemäß irgendeinem der Ansprüche 1 bis 16, einschließlich der Bereitstellung pulsierten Gleichstroms auf ein Sputtertarget während RF Vorspannungs-Strom an ein Substrat, das gegenüber dem Sputtertarget positioniert ist, bereitgestellt wird;
Zügige thermische Glühung (rapid thermal annealing) der LiCoO₂-Schicht bei einer Temperatur von ungefähr 700°C für eine Zeitdauer von weniger als ungefähr 10 min zur Vergrößerung der Korngröße der kristallinen Schicht auf zwischen ungefähr 750 Å und ungefähr 1700 Å;
Aufbringen einer Elektrolytschicht über die LiCoO₂-Schicht; und
Aufbringen eines elektrochemisch aktiven Leiters über die Elektrolytschicht.

## Revendications

1. Un procédé de dépôt d'une couche de LiCoO₂, comprenant :
le placement d'un substrat dans un réacteur ;
l'écoulement d'au moins un gaz inerte au travers du réacteur ;
l'application d'une puissance en courant continu impulsionnel à une cible de pulvérisation comprenant du LiCoO₂ ;
le positionnement de ladite cible à l'opposé dudit substrat ;
la formation d'une couche de LiCoO₂ par-dessus ledit substrat ; et
l'application d'un recuit thermique rapide audit substrat et à ladite couche de LiCoO₂,
où ledit processus de recuit thermique rapide comprend en outre le recuit de ladite couche de LiCoO₂ à une température d'environ 700 °C pendant une période de temps inférieur à environ 10 minutes.

2. Le procédé de la revendication 1, dans lequel ladite étape de recuit thermique rapide est exécutée à une température suffisamment basse en combinaison avec une période de temps suffisamment courte pour assurer un budget thermique suffisamment bas, qui est appliqué au matériau de substrat à basse température.

3. Le procédé de la revendication 1, dans lequel ledit substrat comprend, au moins en partie, un matériau choisi dans le groupe formé par le silicium, les polymères, les verres, les céramiques, l'acier inoxydable et les métaux.

4. Le procédé de la revendication 1, comprenant en outre le dépôt d'une couche de platine sur ledit substrat.

5. Le procédé de la revendication 1, comprenant en outre le dépôt d'une couche électriquement conductrice sur le substrat.

6. Le procédé de la revendication 1, comprenant en outre l'application d'une polarisation RF audit substrat lors de l'application de la puissance en courant continu impulsionnel à ladite cible de pulvérisation.

7. Le procédé de la revendication 1, dans lequel ladite couche de LiCoO₂ comprend, au moins en partie, une structure cristalline.

8. Le procédé de la revendication 1, dans lequel ladite couche de LiCoO₂ comprend, au moins en partie, une structure cristalline et une orientation cristallographique préférentielle dans le plan (101).

9. Le procédé de la revendication 1, dans lequel ladite couche de LiCoO₂ comprend, au moins en partie, une structure cristalline et une orientation cristallographique préférentielle dans le plan (003).

10. Le procédé de la revendication 1, dans lequel ladite couche de LiCoO₂ comprend une dimension de grain comprise entre environ 750 Å et environ 1700 Å.

11. Le procédé de la revendication 7, comprenant en outre le préchauffage dudit substrat à une température d'environ 200 °C avant le dépôt de ladite couche de LiCoO₂.

12. Le procédé de la revendication 1, dans lequel ladite couche de LiCoO₂ est une couche cristalline déposée sans traitement thermique de cristallisation.

13. Le procédé de la revendication 1, comprenant en outre le dépôt d'une couche d'oxyde sur ledit substrat.

14. Le procédé de la revendication 13, dans lequel ladite couche d'oxyde comprend une couche de dioxyde de silicium.

15. Le procédé de la revendication 1, comprenant en outre le dépôt de ladite couche de LiCoO₂ à une vitesse supérieure à environ 1 µm par heure.

16. Le procédé de la revendication 1, dans lequel ladite cible de pulvérisation comprend en outre un matériau choisi dans le groupe des oxydes de Ni, Si, Nb ou autre métal approprié.

17. Le procédé de la revendication 1, dans lequel ladite cible de pulvérisation comprend une cible de pulvérisation en LiCoO₂ céramique avec une résistance mesurée entre des points à environ 4 cm de sa surface inférieure à environ 500 kΩ.

18. Un procédé de production d'une batterie, comprenant :
l'obtention d'un premier conducteur ;
le dépôt d'une couche de LiCoO₂ sur ledit premier conducteur conformément à l'une des revendications 1 à 16, incluant l'application d'une puissance continue impulsionnelle à une cible de pulvérisation tout en délivrant une puissance de polarisation RF à un substrat qui est positionné à l'opposé de la cible de pulvérisation ;
le recuit thermique rapide de ladite couche de LiCoO₂ à une température d'environ 700 °C pendant une période de temps inférieure à environ 10 minutes pour augmenter sa dimension de grain de la couche cristalline d'environ 750 Å à environ 1700 Å ;
le dépôt d'une couche d'électrolyte par-dessus ladite couche de LiCoO₂ ; et
le dépôt d'un conducteur électrochimiquement actif par-dessus ladite couche d'électrolyte.
